(19) Europäisches Patentamt European Patent Office Office européen des brevets

(11) **EP 3 567 562 B1**

(12) **EUROPEAN PATENT SPECIFICATION**

(45) Date of publication and mention of the grant of the patent:
**28.06.2023 Bulletin 2023/26**

(21) Application number: **19182296.4**

(22) Date of filing: **31.05.2010**

(51) International Patent Classification (IPC):
**G08B 13/14** (2006.01)    **H01L 31/02** (2006.01)
**H01L 31/05** (2014.01)    **H02S 40/34** (2014.01)
**H02S 50/10** (2014.01)

(52) Cooperative Patent Classification (CPC):
**G08B 13/1409; G08B 13/1418; H01L 31/02008; H01L 31/05; H02S 40/34; H02S 40/345; H02S 50/10;** Y02B 10/10; Y02E 10/50

(54) **THEFT DETECTION AND PREVENTION IN A POWER GENERATION SYSTEM**

DIEBSTAHLDETEKTION UND -VERHINDERUNG IN EINEM STROMERZEUGUNGSSYSTEM

DÉTECTION ET PRÉVENTION DE VOLS DANS UN SYSTÈME DE GÉNÉRATION DE PUISSANCE

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(43) Date of publication of application:
**13.11.2019 Bulletin 2019/46**

(62) Document number(s) of the earlier application(s) in accordance with Art. 76 EPC:
**10740722.3 / 2 577 630**

(73) Proprietor: **Solaredge Technologies Ltd.**
**Herzeliya 4673335 (IL)**

(72) Inventors:
• **Sella, Guy**
**40294 Beit-Aharon (IL)**
• **Handelsman, Lior**
**53631 Givataim (IL)**
• **Yoscovich, Ilan**
**4673335 Herzeliya (IL)**
• **Adest, Meir**
**4673335 Herzeliya (IL)**
• **Gazit, Meir**
**4673335 Herzeliya (IL)**
• **Galin, Yoav**
**43556 Ra'anana (IL)**
• **Fishelov, Amir**
**69125 Tel-Aviv (IL)**
• **Binder, Yaron**
**71947 Beit Arie (IL)**

(74) Representative: **V.O.**
**P.O. Box 87930**
**2508 DH Den Haag (NL)**

(56) References cited:
WO-A1-2009/026602    DE-U1- 9 312 710
US-A1- 2008 106 250    US-A1- 2009 146 667

**Description**

FIELD AND BACKGROUND

1. Field:

The present invention is related to power generation systems..

2. Related Art:

A photovoltaic power generation system incorporates one or more photovoltaic panels typically mounted on a roof of a building. An inverter located inside the building connects to the photovoltaic panels. The power output from the photovoltaic panels is direct current (DC) power. The inverter converts the direct current power to alternating current (AC) power.

The use of photovoltaic panel based power generation systems are attractive from an environmental point of view. However, the cost of photovoltaic panels and their relative ease of theft, might limit their adoption for use in power generation systems.

There is therefore a need for methods and systems for theft detection and prevention of photovoltaic panels.

US2009146667 discloses a method for testing a photovoltaic panel connected to an electronic module. The electronic module has at least one input attached to the photovoltaic panel and at least one power output. The method of testing the photovoltaic panel begins with activating a bypass of the electronic module. The bypass is preferably activated by applying a magnetic or an electromagnetic field. The bypass provides a low impedance path between the input and output of the electronic module.

DE1993012710 discloses a modular diagnostic system for recognizing and localizing in photovoltaic installations.

US2008106250 discloses a method for monitoring a photovoltaic generator for generating current with a number of solar cells connected between two external connections by repeated feeding of a current with a frequency spectrum into the generator current circuit, detecting thereby a respective frequency response in the frequency spectrum with the supplied current as the input variable and an electric variable of the generator as the output variable, and detecting a change in the frequency response for monitoring the photovoltaic generator in the event of a change during repeated feeding.

WO2009026602 discloses a method for recognition of the theft of at least one solar module on a photovoltaic unit with an inverter an intermediate circuit, a DC-AC converter, at least one solar module connected via connector lines and a control device. A signal unit which can be connected to the connector lines for generating and transmitting an electrical signal and a device for measuring and analyzing the signal received from the at least one solar module are provided such that conclusions can be drawn about the theft of a solar module from the received signal.

The term "memory" as used herein refers to one or more of read only memory (PROM), erasable programmable read only memory (EPROM,) electrically erasable programmable read only memory (EEPROM), FLASH memory, optical memory, e.g. compact disk, switches, random access memory (RAM), magnetic memory such as a hard disk or other memory types known in the art.

A hash function is a transformation that takes an input and returns a fixed-size string or a numeric value, which is called the hash value. The term "hash" as used herein refers to the hash value output of the transformation.

The term "pairing or paired" as used herein refers to at least two power generation system components such as an inverter, photovoltaic panels and/or electronic modules for example which are "paired' or associated with each other. "Pairing" establishes a unique association between for example an inverter (as opposed to other inverters in a power generation system) and a particular set of photovoltaic panels and/ or electronic modules. The "pairing" between power generation components such as an inverter, photovoltaic panel and/ or electronic module is typically performed via assignment codes/ re-hash of codes, signals or permanently attaching additional hardware to each power generation component and each power generation component being aware of the codes/ re-hash of codes, signals or permanently attached additional hardware of other power generation components as part and parcel of a "pairing" process. The "pairing" process may take place at the time manufacture of power generation system components, during installation of a power generation system and/ or during the operation of the power generation system. The codes/ re-hash of codes, signals or permanently attached additional hardware assigned to power generation system components, typically establishes the electrical connections, topographic location, continued presence/ absence, numbers, types of power generation system components within a power generation system.

The terms "sensing" and "measuring" as used herein are used interchangeably.

The term "direct current (DC) power source" as used herein refers to (DC) power source such as batteries, DC motor generator; switch mode power supply (SMPS), photovoltaic panels and/or photovoltaic panels operatively attached to a converter module such as a DC to DC converter.

The term "photovoltaic source" as used herein refers to a photovoltaic panel and/ or a photovoltaic panel operatively attached to a converter module such as a DC to DC converter.

The term "central unit" as used herein refers to a load such as an inverter or an element such as a control circuit attached directly to the load or in the immediate vicinity of the load.

BRIEF SUMMARY

The present invention is defined in the appended claims. According to an aspect of the present disclosure there is provided a method for preventing theft of components from a system for generating electrical power. The system includes an inverter connected to a photovoltaic source. A first memory is permanently attached to the photovoltaic source. A microprocessor and a second memory are attached to the inverter. A first code is written in the first memory and a second code is stored in the second memory based on the first code. The second code is preferably either a copy or a hash of the first code. The writing of the first code and/or the storing of the second code is preferably performed during installation of the system. The writing of the first code and/or the storing of the second code is optionally performed by a remote server attached to the system. After the first code is read and stored in the first memory, and the second code is read and stored in the second memory during the electrical power generation, the first code is compared with the second code or its hash. Power conversion and/or inversion is initialized or continued based on the comparison of the first code with the second code. The reading of the first and second codes and the comparison are preferably performed by the microprocessor. Alternatively, a remote server operatively attached to the microprocessor receives the first code and the second code. The remote server stores in remote storage attached to the remote server either copies of the first code and the second code or a hash based on the first code and the second code. Prior to initializing/continuing power conversion operation of the inverter, the remote server receives the first and second codes. The remote server compares the first and second codes to the copies/hash previously stored. If the comparison is correct, (for instance the codes correspond) then power conversion by the inverter is allowed. Optionally, the first code or the second code or portion thereof is generated by a global positioning system module which bases the first code or the second code on the global coordinates of the photovoltaic source or the inverter.

According to another aspect of the present disclosure there is provided a method of preventing theft of a system for generating electrical power. The system includes an inverter connected to a photovoltaic source. A first memory is permanently attached to the photovoltaic source. A second memory is attached to the inverter. A first code is written in the first memory and a second code is stored in the second memory based on the first code. The second code is preferably either a copy or a hash of the first code. The writing of the first code and/or the storing of the second code is preferably performed during installation of the system. The first code and the second code are compared preferably during or prior to the electrical power generation. The comparison may be performed by a processor either a first processor attached to the photovoltaic source and configured to address the first memory, a second processor attached to the inverter configured to address the second memory and/or a remote server attached to either the first processor or the second processor over a wide area network. Based on the comparison, either the power conversion of the inverter is disabled or the electrical power output of the photovoltaic source to the inverter is disabled. The first code or the second code of respective portions thereof may be based on global coordinates.

According to another aspect of the present disclosure there is provided a system for generation of electrical power including an inverter connected to a photovoltaic source having a theft prevention and detection feature. A first memory is permanently attached to the photovoltaic source. The first memory is configured to store a first code. A second memory is attached to the inverter. The second memory configured to store a second code. During manufacture or installation of the system, the first code is stored in the first memory attached to the photovoltaic source. The second code based on the first code is stored in the second memory. Prior to operation of the inverter, the first code is compared to the second code and based on the comparison. The generation of the electrical power may be enabled or disabled. The comparison is performed by a processor: a first processor attached to the photovoltaic source addressing the first memory, a second processor attached to the inverter addressing the second memory and/or a remote server attached to selectably either the first processor or the second processor over a wide area network. The system optionally includes a global position module located at the site of the inverter or the site of the panel The first code or the second code is based on global coordinates generated by the global position module.

According to another aspect of the present disclosure there is provided a theft detection device in a system for generating electrical power, the system including a direct current (DC) power source and a load connectible to the DC power source with a DC power line. The theft prevention device has an alternating current (AC) source operatively attached between the load and the DC power source. The AC source is preferably arranged for superimposing an AC current onto the DC power line. A receiver located in vicinity of the alternating current (AC) source. An impedance probe operatively attached to the DC power line. The impedance probe is arranged for sensing impedance responsive to the AC current. The impedance probe may include a voltage probe and a current probe, an energy storage device, a memory arranged to store an impedance datum and/ or a transmitter which is arranged to transmit the impedance datum. A potential theft of a component of the system is alerted which is responsive to a change in the impedance greater than a previously determined threshold.

According to another aspect of the present disclosure there is provided a method for theft detection in a system for generation of electrical power, the system including a DC power line. An alternating current (AC) is applied to the DC power line from an alternating current (AC) source and an impedance component of the system is sensed. The impedance is responsive to the applied alternating current (AC). An impedance datum proportional to the impedance is stored with the impedance datum transmitted to a receiver. Electrical charge is stored to power the sensing when the system is not generating electrical power. The sensing includes measuring voltage and current of the alternating current (AC) source. A potential theft of a component of the system is alerted which is responsive to a change in the impedance greater than a previously determined threshold or upon not receiving an expected transmission of the impedance datum.

According to another aspect of the present disclosure there is provided a theft detection device in a system for generating electrical power. The system includes a direct current (DC) power source with DC outputs. The DC outputs are connectible to a load with a DC power line. The theft prevention device has an impedance probe connectible to the DC outputs and the DC power line. The impedance probe includes a transmitter configured to transmit probe signal. A receiver module is operatively attached to the direct current (DC) power source and the load. The receiver module includes a receiver configured to receive the probe signal. The probe signal may include data encoded using power line communications. A module is operatively attached to the direct current (DC) power source and the load. The module includes a receiver configured to receive the probe signal and/or the data. The impedance probe may include a voltage probe and a current probe, energy storage device and/ or memory arranged to store an impedance datum.

According to another aspect of the present disclosure there is provided a method for theft detection in a system for generation of electrical power. The system includes a direct current (DC) power source. An impedance of the DC power source is measured from which an impedance datum is stored which is proportional to the impedance. The impedance datum is transmitted and received. The impedance datum is compared with a previously stored datum and a potential theft of DC power source responsive to the comparison is alerted. The measured impedance may include measured voltage and current of the DC power source. Electrical energy may be stored for supplying power for the measuring of impedance and for supplying power for the receiving of impedance datum.

According to an aspect of the present disclosure there is provided a theft detection device in a distributed electrical power generation system including a direct current (DC) power source connected to an electronic module with DC outputs. The DC outputs are connectible to a load with a DC power line. A central impedance probe is connectible to the DC power line. The central impedance probe includes a impedance sensing module arranged for sensing impedance of the DC power source. An electronic module may include a bypass switch adapted to present impedance of said photovoltaic panel to said central impedance probe.

According to an aspect of the present disclosure there is provided a theft detection method of theft protection in a distributed electrical power generation system including a direct current (DC) power source with DC outputs. The DC outputs are connectible to a load with a DC power line. A central impedance unit is connected to the DC power line. A probe signal is transmitted on the DC power line and impedance is sensed responsive to said probe signal. The sensed impedance is compared to a previously stored impedance value of the direct current (DC) power source, and an alert may be performed based on the comparison of impedance values. The probe signal may be an AC power feed , a power line communication signal or a dedicated signal for the impedance measurement. The electronic module may be bypassed to present impedance of the power source, e.g. photovoltaic panel, to the central impedance probe.

According to another aspect of the present disclosure there is provided a theft detection device in a photovoltaic system for generating electrical power. The theft detection device has an electronic module attached to a photovoltaic source. An image sensor is preferably arranged for capturing images of the photovoltaic source. A central controller is arranged to provide a signal to the electronic module. A thermal property of the photovoltaic source changes which is responsive to the signal. A load is preferably connected to the electronic module and the load is typically an inverter. The image sensor is a thermal image sensor. The electronic module may include a receiver, direct current (DC) to DC converter or a DC to alternating current (AC) converter.

According to another aspect of the present disclosure there is provided a method for theft detection in a system for generation electrical power, the system including an electronic module attached to a photovoltaic source. The electronic module is signaled whereupon after receiving the signaling, the photovoltaic source is reverse biased, thereby causing increased heat dissipation in the photovoltaic source. Image frames are captured of the photovoltaic source and the image frames are analyzed for thermal changes responsive to the signaling. The presence of the photovoltaic source is ascertained based on the analyzing of the image frames and potential theft is alerted of the photovoltaic source based on the ascertaining. The signaling typically causes the electronic module to reverse bias the photovoltaic source.

According to another aspect of the present disclosure there is provided a theft detection device in a system for generating electrical power, the system including an inverter connected to a photovoltaic source, the theft detection device has a transmitter attached to the photovoltaic source. The transmitter arranged for transmitting a signal and a receiver is arranged for receiving the signal. The transmitter may be arranged to store electrical charge.

According to another aspect of the present disclosure there is provided a method for theft detection in a system for generation electrical power, the system including an inverter connected to and receiving power from a photovoltaic source, a transmitter operatively attached to the photovoltaic source and a receiver. A signal is transmitted from the transmitter. The signal is monitored and upon an absence of the signal being sensed a potential theft of the photovoltaic source is alerted or alarmed.

According to another aspect of the present disclosure there is provided a theft detection device in a system for generating electrical power, the system including an inverter connected to a photovoltaic source. The theft prevention device has a transmitter attached to the photovoltaic source and the transmitter is arranged for transmitting a signal. A receiver attached to the photovoltaic source is arranged for receiving the signal and a controller is operatively attached to the receiver and the transmitter.

According to another aspect of the present disclosure there is provided a method for theft detection in a system for generating electrical power, the system including an inverter connected to a photovoltaic source, a transmitter and receiver attached to the photovoltaic source. The signal strength of the transmitter is measured using the receiver and an object in vicinity of the photovoltaic source is detected by virtue of change in the measuring. A potential theft of the photovoltaic source is alerted based on the detecting;

According to another aspect of the present disclosure there is provided a theft detection device in a system for generating electrical power, the system including an inverter connected to a photovoltaic source, the theft detection device has a sensor measuring electric field strength of the photovoltaic source and a controller operatively attached to the sensor.

According to another aspect of the present disclosure there is provided a method for theft detection in a system for generating electrical power, the system including an inverter connected to a photovoltaic source, a sensor operatively attached to the photovoltaic source and a controller operatively attached to the sensor. The electric field of the photovoltaic source is measured using the sensor. The measuring is arranged to indicate a change in threshold of the electric field. An object in vicinity of the photovoltaic source is detected by virtue of change in threshold of the electric field. Potential theft of the photovoltaic source is alerted using the controller.

According to another aspect of the present disclosure there is provided a theft detection device in a system for generating electrical power, the system including a photovoltaic string and a load connectible to the photovoltaic string with a DC power line, the theft prevention device has a central control unit operatively attached between the load and the photovoltaic string. The central control unit is arranged for superimposing a control signal and a test signal onto the DC power line. A switch unit operatively attached to the photovoltaic string. The switch unit is arranged for receiving the control signal and the test signal.

According to another aspect of the present disclosure there is provided a method for theft detection in a system for generation electrical power, the system including a photovoltaic source and a load connectible to the photovoltaic source with a DC power line, a central control unit operatively attached between the load and the photovoltaic source and a switch unit with a resonant circuit, the switch unit operatively attached to the photovoltaic source. A first control signal from the central control unit is superimposed onto the DC line. The resonant circuit is connected to the photovoltaic source. The resonant circuit is responsive to the control signal. A second control signal from the central control unit is superimposed onto the DC line. A reflected signal responsive to the second superimposing is sensed. The test signal is a time domain reflectometry (TDR) signal or a frequency domain reflectometry (FDR) signal. The sensing may be in terms of sensing phase shift of the reflected signal, sensing frequency shift of the reflected signal and/ or sensing amplitude change of the reflected signal.

According to an aspect of the present disclosure there is provided a theft detection device in a system for generating electrical power. The device includes multiple electronic modules attached to multiple photovoltaic sources. At least one of the electronic modules is arranged for constructing a confirmation signal. A central control unit is operatively attached to at least one of the electronic modules. The central control unit is arranged for sending a signal to the at least one electronic module and for receiving the confirmation signal. The confirmation signal typically includes information that the at least one electronic module collects from other electronic modules in the immediate vicinity of the at least one electronic module. The central control unit may alert of potential theft based on the confirmation signal.

According to an aspect of the present disclosure there is provided a method of theft detection in a system for generation electrical power. The system includes multiple photovoltaic sources, and multiple electronic modules attached to the photovoltaic sources and a central control unit. The central control unit is operatively attached to the electronic modules. A signal is sent from the central control unit to at least one of the electronic modules. The at least one electronic module is arranged for constructing a confirmation signal which is sent to the central controller in response. The constructed confirmation signal typically includes information that the at least one electronic module collects from other electronic modules in the immediate vicinity of the at least one electronic module. The confirmation signal is based on or includes data collected from the electronic modules connected in a mesh network. The data is received at the central control unit. The confirmation signal may be decoded and the decoded data are compared with a look up table stored at the central control unit. Potential theft of one of the photovoltaic sources may be alerted by the central control unit.

The foregoing and/or other aspects will become apparent from the following detailed description when considered in conjunction with the accompanying drawing figures.

BRIEF DESCRIPTION OF THE DRAWINGS

Embodiments of the present invention are described below, by way of example only, with reference to the accompanying drawings, in which:

Figure 1a illustrates an electrical power generation system including a theft prevention feature according to an embodiment of the present invention;

Figure 1b illustrates in more detail a communications module and a memory of the power generation system of Figure 1a;

Figures 1c and 1d illustrate a process flow of a method for theft prevention, according to embodiments of the present invention;

Figure 1e illustrates an electrical power generation system with a theft prevention feature, according to another embodiment of the present invention;

Figures 1f and 1g illustrate a process flow of a method for theft prevention of in the system of Figure 1e;

Figures 1h illustrates an electrical power generation system, according to yet another embodiment of the present invention;

Figures 1i and 1j illustrate a process flow of a method for theft prevention of the electrical power generation system of Figure 1h;

Figure 1k illustrates an electrical power generation system with a theft prevention feature, according to still another embodiment of the present invention.

Figures 1l and 1m illustrate a process flow of a method for theft prevention of the electrical power generation system of Figure 1k.

Figure 2a shows a power generation system including a theft prevention feature according to an embodiment of the present invention.

Figure 2b shows further details of receiver / current source unit and impedance unit connected as shown in Figure 2a according to an embodiment of the present invention.

Figure 2c shows a method for theft detection of a power generation system, according to an aspect of the present invention.

Figure 2d shows an alternative embodiment of the impedance unit shown in Figure 2b.

Figure 2e shows a power generation system including a theft prevention feature according to an embodiment of the present invention.

Figure 2f shows a method for theft detection according to an embodiment of the present invention using the power generation system shown in Figure 2e.

Figure 2g shows a power generation system including a theft prevention feature according to an embodiment of the present invention.

Figure 2h which shows a method of theft protection in a distributed electrical power generation system according to an embodiment of the present invention.

Figure 3a shows a power generation system including a theft prevention feature according to an embodiment not forming part of the present invention.

Figure 3b shows a typical topography of the power generation system (shown in Figure 3a) including a theft prevention feature according to an embodiment not forming part of the present invention.

Figure 3c shows a method for theft detection according to an embodiment not forming part of the present invention using the system of Figure 3a with topography shown in Figure 3b.

Figure 4a shows a power generation system including a theft prevention feature according to an embodiment not forming part of the present invention.

Figure 4b shows a method for theft prevention using the system shown in Figure 4a, according to an embodiment not forming part of the present invention.

Figure 4c shows a power generation system including a theft prevention feature according to an embodiment not forming part of the present invention.

Figure 4d shows a method of theft detection/ prevention according to an embodiment not forming part of the present invention.

Figure 5a shows a power generation system including a theft prevention feature according to an embodiment not forming part of the present invention.

Figure 5b shows a typical cross section of photovoltaic panel according to an embodiment not forming part of the present invention.

Figure 5c shows a plan view photovoltaic panel according to an embodiment of the present invention.

Figure 5d shows an equivalent capacitor representing a photovoltaic panel according to an embodiment not forming part of the present invention.

Figure 5e shows a method for theft detection/ prevention according to an embodiment not forming part of the present invention.

Figure 6a shows a power generation system including a theft prevention feature according to an embodiment not forming part of the present invention.

Figure 6b shows further details of photovoltaic module according to an embodiment not forming part of the present invention

Figure 6c shows a method for theft detection/ prevention using the system shown in Figure 6a according to an embodiment not forming part of the present invention

Figure 7a which shows a power generation system including a theft prevention feature according to an embodiment not forming part of the present invention.

Figure 7b which shows a method for theft detection/ prevention according to an embodiment not forming part of the present invention.


DETAILED DESCRIPTION

Reference will now be made in detail to embodiments of the present invention, examples of which are illustrated in the accompanying drawings, wherein like reference numerals refer to the like elements throughout. The embodiments are described below to explain the present invention by referring to the Figures.


**Code storage**

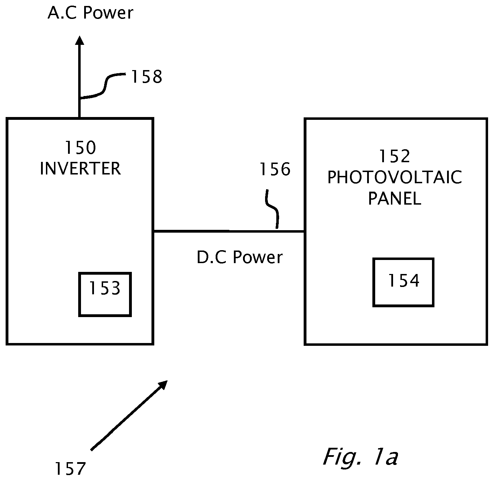

Referring now to the drawings, Figure 1a illustrates an electrical power generation system **157** including a theft prevention feature according to an embodiment of the present invention. System **157** includes one or more photovoltaic panels **152** connected to an inverter **150** by a direct current (DC) power cable **156**. During operation of electrical power generation system **157**, DC power is produced by photovoltaic panel **152** and transferred to the input of inverter **150** via DC cable **156**. Inverter **150** converts the DC power at its input to AC power at inverter **150** output **158**. A memory module **154** is permanently attached to photovoltaic panel **152**. A communication module **153** is attached to inverter **150**. The term "permanently attached" as used herein refers to a method or device for attachment such that physical removal or attempt thereof, *e.g.* of memory module **154** from photovoltaic panel **152**, would likely result in damage, *e.g.* to module **154** and/or panel **152**. Typically, during manufacture of the photovoltaic (PV) panel **152** and/or inverter **150**, modules **154**, **153** are "permanently attached" respectively to photovoltaic panel **152** and/or inverter **150**. For example, when module **154** is permanently attached to the photovoltaic panel **152**, the operation of photovoltaic panel **152** ceases or connections thereof are broken on attempting to remove module **154** from photovoltaic panel **152**. Any mechanism known in the art for "permanently attaching" may be applied in different embodiments of the present invention. One such mechanism for permanently attaching uses a thermoset adhesive, e.g. epoxy based resin, and hardener.

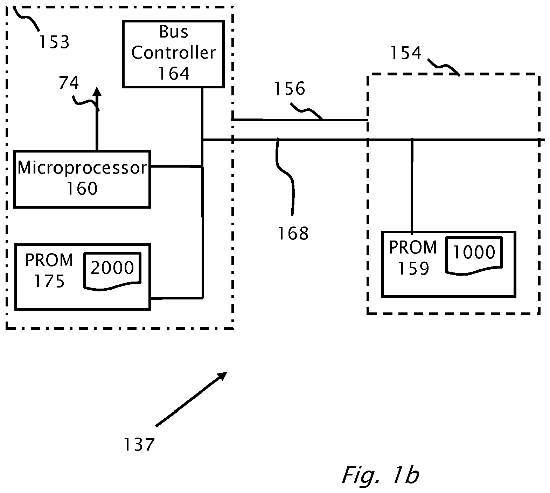

Reference is now also made to Figure 1b, which illustrates in more detail **137** communications module **153** and memory module **154** of system **157**. A communications cable **168** connects memory module **154** to communications module **153**. Power cable **156** which transfers DC power from photovoltaic panel **152** to the input of inverter **150**, is optionally a multi-core cable in which at least two wires of the multi-core cable preferably are used for a communication cable **168**. If a long distance, separates inverter **150** from photovoltaic panel **154** communication cable **168** is preferably a twisted pair cable. In another embodiment, communications are superimposed on DC power line **156**, i.e. power line communications. In another embodiment, radio frequency wireless communication may be used either centrally from inverter to power sources or a mesh network may be used. Communication module **153** attached to inverter **150** preferably includes a bus controller **164** (*e.g.* Cyclone™1C3, i²c bus controller, Altera, 101 San JoseCA95134) which controls communications over cable **168**. Bus controller **164** is preferably connected to a microprocessor **160**. A memory **175**, is preferably connected to both bus controller **164** and microprocessor **160**. Microprocessor **160** preferably outputs a signal **174**, which is used to allow and/or disallow the operation of inverter **150** for converting DC power to AC power. Memory module **154** which is permanently attached to photovoltaic panel **152** includes a memory **159**. Memory **159** is connected to bus controller **164** in communication module **153** by communication cable **168**. Memory **159** stores a code **1000**. Memory **175** stores a code **2000**.

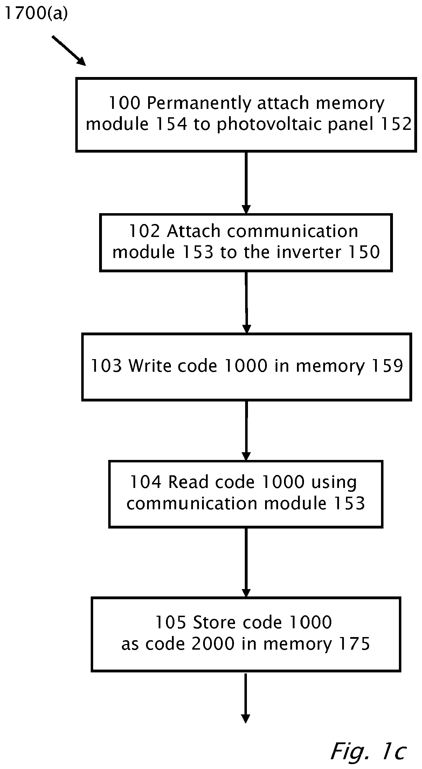

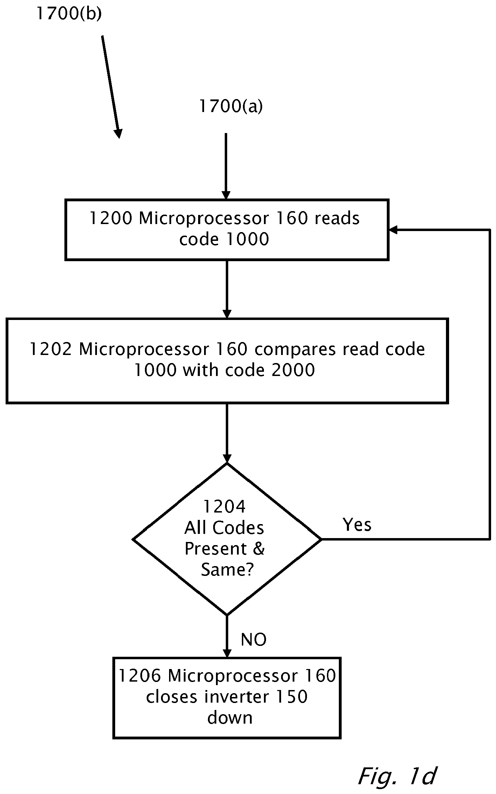

Reference is now also made to Figures 1c and 1d which show a process flow **1700(a)** of a method **1700** for theft prevention which illustrates pairing in electrical power generation system **157**, according to an embodiment of the present invention. Typically, during manufacture, memory module **154** is permanently attached (step **100**) to photovoltaic panel **152**. In step **102**, communication module **153** is attached to inverter **150**. Although steps **100** and **102** are typically performed during manufacture or assembly of photovoltaic panel **152** and/or inverter **150**, steps **100** and **102** may be performed as a retrofit or during installation. In step **103**, code **1000** is written in memory **159** during manufacture of photovoltaic panel **152** or during installation of photovoltaic panel **152**. Communication module **153** reads (step **104**) code **1000** using bus controller **164** and microprocessor **160**. Microprocessor **160** stores (step **105**) a copy or hash of code **1000** read in step **104** into code **2000** in memory **175**. Although, method steps **103, 104** and **105** are typically performed during installation of photovoltaic panel **152** and inverter **150,** steps **103, 104** and **105** may be performed during manufacture and/or assembly of photovoltaic panel **152** and/or of inverter **150**. Method **1700** continues in Figure 1d as sub-process **1700(b)** performed typical during power generation operation of system **157**. Microprocessor **160** reads (step **1200**) code **1000** in memory module **154**. In step **1202**, microprocessor **160** compares code **1000** with code **2000** previously stored in communication module **153** and memory module **175**. In decision box, **1204** if codes **1000** and **2000** are the same or otherwise correctly compare then output **174** is set by microprocessor **160** to allow the power conversion of DC to AC of inverter **150** and anti-theft process **1700** continues at step **1200**. Otherwise power conversion DC/AC of inverter **150** is disabled (step **1206**) by microprocessor **160** using output **174**.

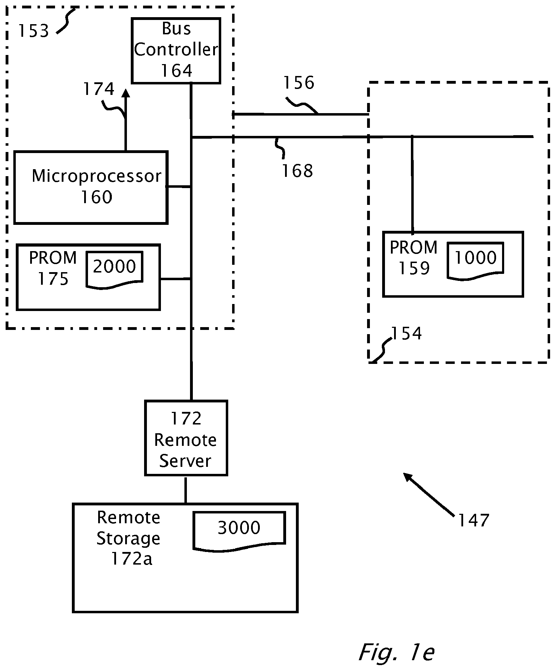

Reference is now made to Figure 1e which illustrates another embodiment of the present invention, photovoltaic system **147** with a theft prevention feature. Memory module **154** is permanently attached to photovoltaic panel **152** (not shown in Figure 1e). Memory module **154** includes memory **159** for storing code **1000**. Memory **159** is connected to bus controller **164** in communication module **153** by communication cable **168**. Communication module **153** is attached to inverter **150** (not shown in Figure 1e). Bus controller **164** is connected to microprocessor **160** and memory **175** for storing code **2000**. A remote server **172** is connected to microprocessor **160** by bus **168,** by a dedicated WAN interface (not shown) or by other suitable communications method. Remote server **172** is connected to a remote storage **172a**. Remote storage **172a** preferably stores copies or hashes of codes **1000** and **2000**. Microprocessor **160** has output signal **174**, which is activated by remote server **172** to allow the operation of inverter **150** to convert DC Power to AC power.

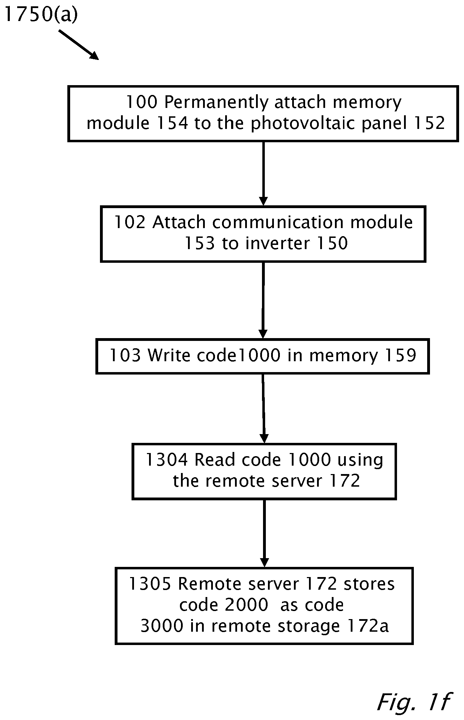

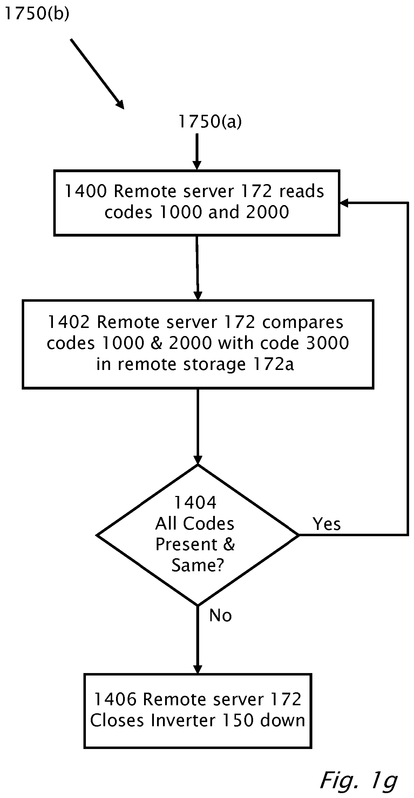

Reference is now also made to Figures 1f and 1g which illustrate process flow of a method **1750** for theft prevention of electrical power generation system **147** (of Figure 1e) according to an embodiment of the present invention using. In step **100,** memory module **154** is permanently attached to photovoltaic panel **152**. In step **102** communication module **153** is attached to inverter **150.** In step **103,** code **1000** is written in memory **159** during manufacture of photovoltaic panel **152** or during installation of photovoltaic panel **152**. Remote server **172** reads (step **1304**) code **1000** preferably using bus controller **164**. Remote server **172** stores (step **1305**) copies or hashes of code **1000** and code **2000** as code **3000** at remote storage **172a**. Method steps **103, 1304** and **1305** are typically performed during installation of photovoltaic panel **152** and inverter **150**. Method **7150** continues in Figure 1g as sub-process **1750(b)** during which steps **1400**, **1402**, **1404** and **1406** are performed during the power generation operation of system **147**. To protect against theft during operation, remote server **172** reads codes **1000** and **2000** (step **1400**). In step **1402**, remote server **172** compares the code reads in step **1400** with code **3000** in remote storage **172a**. In step **1404** if codes (**1000, 2000**) and **3000** are the same or when code **3000** is a hash of codes **1000** and **2000**, and code **3000** compares correctly with codes **1000** and **2000,** then output **174** of microprocessor **160** activated via remote server **172,** to allow the power conversion of DC to AC of inverter **150** and operation continues at step **1400**. Otherwise, remote server **172** does not allow inverter **150** to convert DC power to AC power (step **1406**).

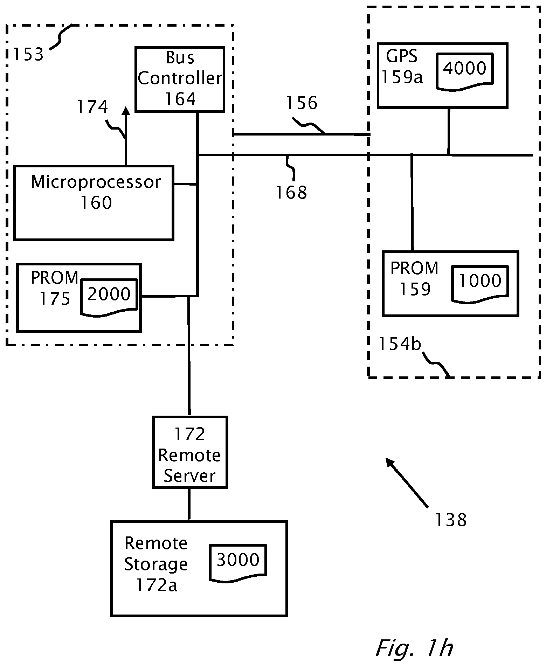

Reference is now made to Figure 1h of a system **138,** according to another embodiment of the present invention for theft prevention of photovoltaic system **157**. Communication module **153** is attached to inverter **150** (not shown) and contains bus controller **164** connected to a microprocessor **160** and memory **175** having a code **2000**. Connected to bus controller **164** is a remote server **172**. Remote server **172** is connected to remote storage **172a**. Microprocessor **160** has output signal **174**, which is activated by remote server **172** to allow the operation of inverter **150** to convert DC Power to AC power. Memory module **154b** permanently attached to photovoltaic panel **154b** includes memory **159** (*e.g.* EPROM, EEPROM, FLASH or other suitable memory), having a code **1000** and a Global Position System (GPS) module **159a** having a code **4000**. Code **4000** is based on global coordinates of photovoltaic panel **152** during installation of panel **152**. Memory **159** and GPS module **159a** are preferably connected to microprocessor **160** by bus controller **164** in communication module **153** by a communication cable **168.**

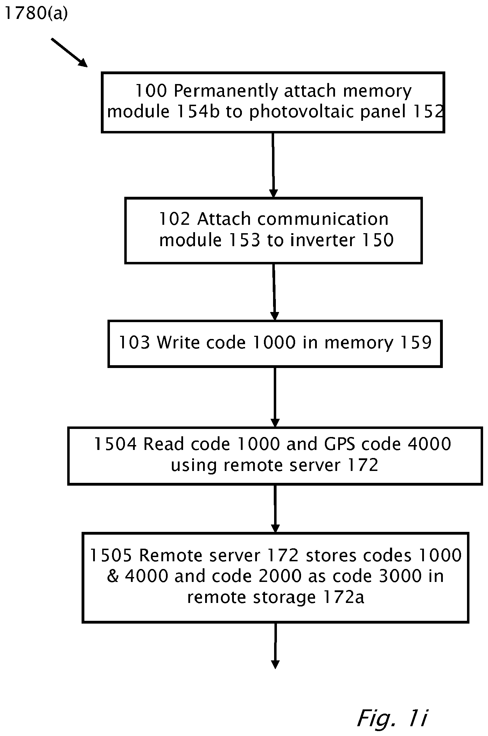

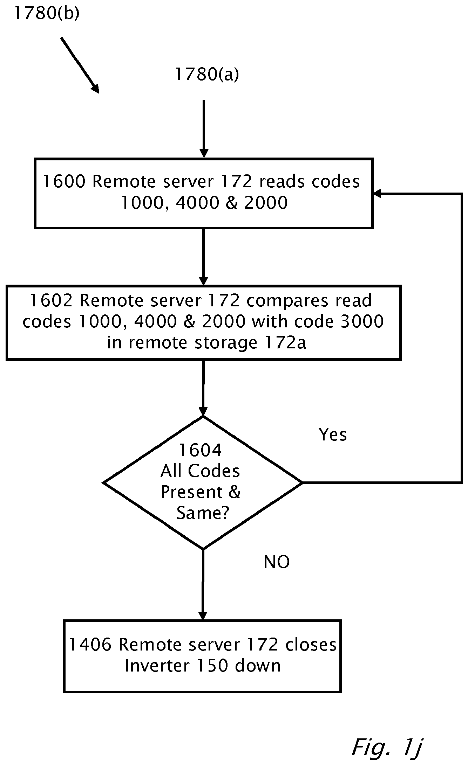

Reference is now also made to Figures 1i and 1j which illustrate a process flow of a method **1780** for theft prevention of electrical power generation system **138** (Figure 1h) according to an embodiment of the present invention. In step **100**, typically performed during manufacture and/or assembly of electrical power generation system **138,** memory module **154b** is permanently attached to photovoltaic panel **152**. In step **102**, communication module **153** is attached to inverter **150**. In step **103**, code **1000** is written in memory **159** during manufacture or assembly of photovoltaic panel **152** or at installation of photovoltaic panel **152**. Remote server **172** reads (step **1504**) code **1000** and code **4000** of GPS module **159a** using bus controller **164**. Remote server **172** stores a copy/hash of codes **1000** and **4000** read in step **1504** into code **2000** in memory **175** and in code **3000** of remote storage **172a** (step **1505**). Method steps **103, 1504** and **1505** are typically performed during installation of photovoltaic panel **152** and inverter **150**. Method **1780** continues in Figure 1j as sub-process **1780(b)** performed during power conversion operation of system **138**. To protect against theft, remote server **172** reads (step **1600**) codes **1000, 2000** and **4000**. In step **1602**, remote server **172** compares codes (**1000**, **2000** and **4000** ) read in step **1600** with code **3000** in remote storage **172a.** At step **1604,** if codes (**1000, 2000, 4000)** and **3000** are the same or otherwise compare correctly, output **174** of microprocessor **160** via remote server **172**, allows the power conversion of DC to AC of inverter **150** and operation continues at step **1600**. Otherwise remote server **172** does not allow inverter **150** to convert DC power to AC power (step **1406**).

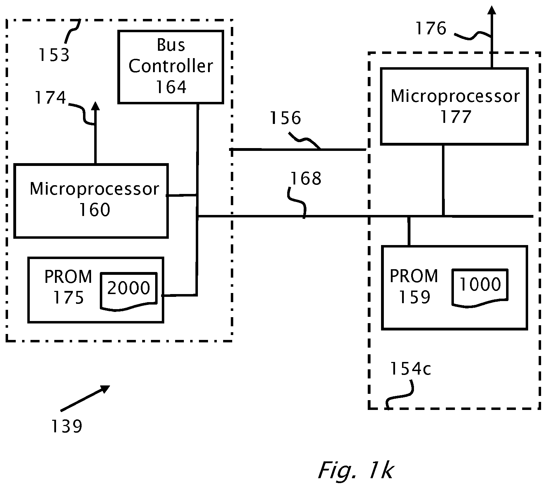

Reference is now made to Figure 1k of photovoltaic system **139,** which illustrates another embodiment of theft prevention according to the present invention. Communication module **153** attached to inverter **150** contains a bus controller **164** connected to microprocessor **160** and memory **175**, having code **2000**. Microprocessor **160** has an output signal **174**, which is used to allow the operation of inverter **150** to convert DC Power to AC power. Memory module **154c** permanently attached to photovoltaic panel **152** contains memory **159**, having a code **1000** and microprocessor **177** with output **176**. Memory **159** and microprocessor **177** are connected to bus controller **164** in communication module **153** by communication cable **168**.

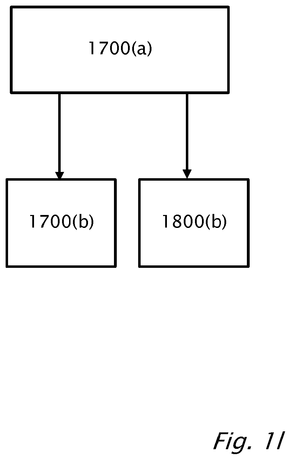

Reference is now made to Figure 1l which illustrates sub-processes **1700(b)** and **1800(b)** being performed in parallel during power conversion operation after manufacturing/installation is performed according to sub-process **1700(a).** Sub-processes **1700(b)** and **1800(b)** work together in parallel and at the same time to achieve theft detection and prevention of electrical power generation system **139**, according to an embodiment of the present invention. Sub-process **1700(b)** illustrates the use of microprocessor **160** for theft detection and prevention of electrical power generation system **139.** Sub-process **1800(b)** illustrates the use of microprocessor **177** for theft detection and prevention of electrical power generation system **139.**

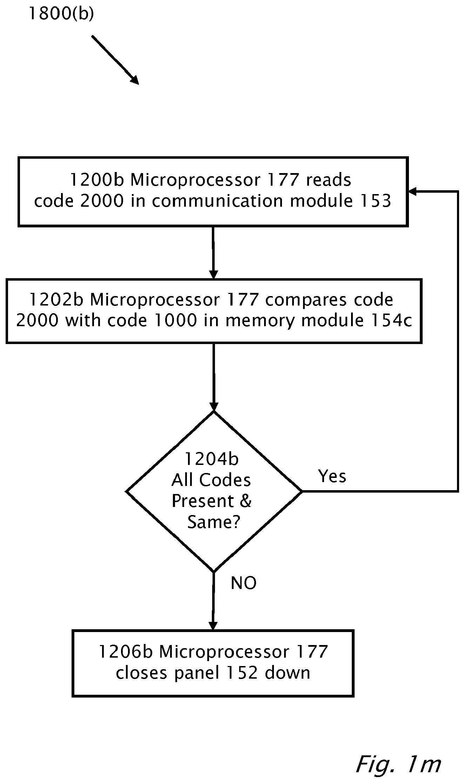

Referring now to Figure 1m, sub-process **1800(b)** in step **1200b** microprocessor **177** reads code **2000** in communication module **153** by signaling over communications bus **168**. In step **1202b,** microprocessor **177** compares code **2000** with code **1000**. If in decision box **1204b,** codes **1000** and **2000** are not the same, output **176** of microprocessor **177** is used to shut down photovoltaic panel **152** (step **1206b**). Photovoltaic panel **152** may be shut down by several mechanisms, by simple bypass using a bypass diode in parallel with photovoltaic panel **152** or by turning off a DC/DC conversion circuit if present in module **154.**

A supervisory mechanism is provided to remove the pairing in order to perform repairing using different inverters **150**and modules **154**

**Impedance Measurement**

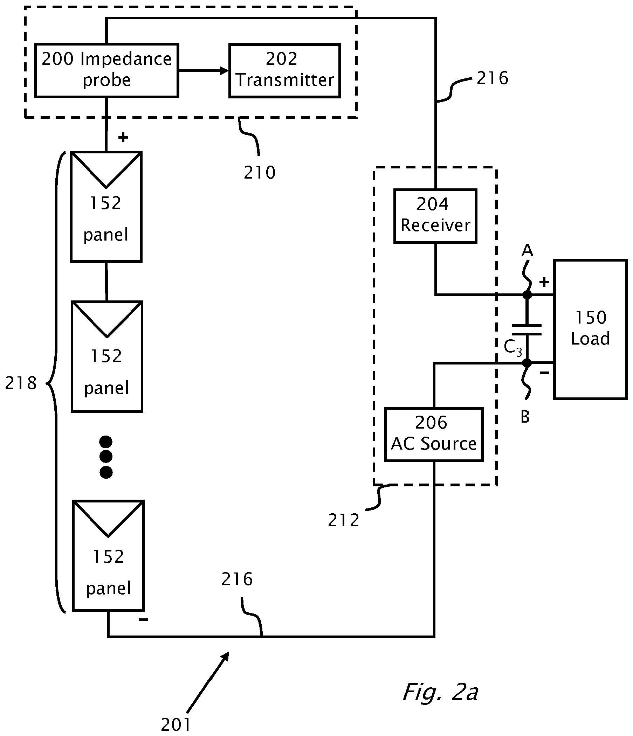

Reference is now made to Figure 2a which shows a power generation system **201** including a theft prevention feature according to an embodiment of the present invention. Power generation system **201** has at least one string **218** of photovoltaic panels **152**, an impedance unit **210**, a unit **212**, capacitor $C_3$, DC power line **216** and load **150**. Load **150** is preferably an inverter. Impedance unit **210** has an impedance probe **200** which is connected serially via direct current (DC) line **216** between the positive output of string **218** and unit **212.** When more than one string **218** is present each string **218** typically includes its own impedance probe **200.** Unit **210** may optionally be incorporated in load 150. Impedance unit 210 senses impedance of panels 152 with an output connected to a transmitter 202. During daytime operation, impedance unit 210 may be powered by the current in string 218 or by attaching the probe to a single photovoltaic panel and receiving power from the photovoltaic panel in parallel with the string. Impedance unit 210 and/ or unit 212 may have a charge storage element such as a battery or capacitor for nighttime operation with the charge storage element being charged during daytime operation. Transmitter 202 periodically transmits a signal proportional to the measured impedance by impedance probe 200. Unit 212 has receiver 204 and an alternating current (AC) source module 206. Unit 212 is connected serially between unit 210 and negative output of string 218. Unit 210 may be incorporated in a panel 152 or in an electronic module 302 (not shown) which is operatively attached/permanently attached to a photovoltaic panel 152. Load 150 has a DC input which is serially connected between receiver 204 and alternating current source module 206 at nodes A and B respectively. Current source module 206 is optional and may be not needed if unit 210 includes a charge storage. A capacitor $C_3$ connects between nodes A and B. Receiver 204 is serially connected between the positive output of string 218 and node A. Alternating current source module 206 is serially connected between node B and the negative output of string 218. AC source module 206 is connected to string of panels 152 and superimposes an AC signal on DC power lines 216. Impedance probe 200 attached to the string of panels 152 measures impedance preferably by independently measuring AC current and AC voltage along the string of panels.

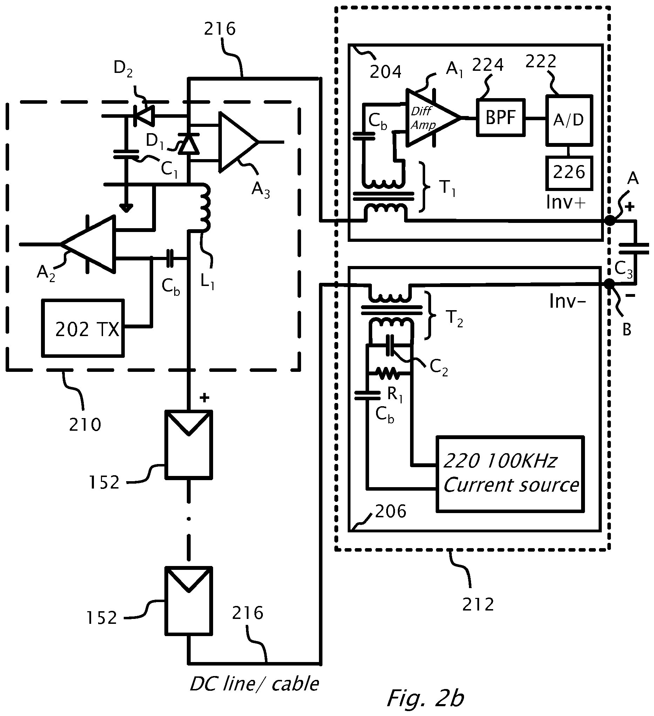

Reference is now made to Figure 2b which shows further details of unit 212 and impedance unit 210 connected as shown in Figure 2a according to an embodiment of the present invention. Load 150 connected at nodes A and B is not shown. Unit 212 has a receiver 204 and AC source module 206. AC source module 206 includes an AC current source 220 which operates at a frequency typically of 100 KHz. The AC current of source 220 is superimposed on to DC line 216 via transformer $T_2$ or any other AC coupling device. One side of transformer $T_2$ coil is connected in shunt to a capacitor $C_2$ and resistor $R_1$ connected in parallel. One end of $R_1$ is connected to the output of current source **220**. The other end of $R_1$ is connected to the other output of current source **220** via a DC blocking capacitor $C_b$. The other side of transformer coil $T_2$ is connected in series between node **B** and panels **152** via DC line **216.** Receiver **204** receives an input of AC present on DC line **216** via one coil of transformer $T_1$ connected in series between node **A** and impedance unit **210** via DC line **216**. The other coil of transformer $T_1$ is connected at one end to the input of a differential amplifier $A_1$ and the other end of the coil to the other input of amplifier $A_1$ via a blocking capacitor $C_b$. The output of amplifier $A_1$ connects into the input of a band pass filter (BPF) **224**. The output of band pass filter (BPF) **224** connects into the input of an analogue to digital (A/D) converter **222**. The output of analogue to digital (A/D) converter **222** operatively attached to processor **226** (with memory).

Impedance unit **210** is connected in series between panels **152** and receiver **204** via DC line **216**. The positive DC output of panels **152** is connected to one end of an inductor Li and one end of a DC blocking capacitor $C_b$. The other end of DC blocking capacitor $C_b$ connects to the input of transmitter **202** as well as to the input of amplifier $A_2$. The other input of amplifier $A_2$ connects to one end of capacitor $C_1$, the anode of a diode $D_1$ and the other end of inductor $L_1$. Capacitor $C_1$ may serve as a charge storage device to provide power to impedance unit **210** during night-time operation. The cathode of $D_1$ connects the anode of diode $D_2$. The cathode of $D_2$ connects to the other end of capacitor $C_1$. The node where the cathode of $D_1$ connects the anode of diode $D_2$ provides the connection to DC line **216**. Amplifier $A_3$ has an input which connects across diode $D_1$. The output of amplifier $A_2$ may be connected to the input of an analogue to digital (A/D) converter (not shown) with an output connected to a memory storage device (not shown). The output of amplifier $A_3$ may be connected to the input of an analogue to digital (A/D) converter (not shown) with an output connected to a memory storage device (not shown).

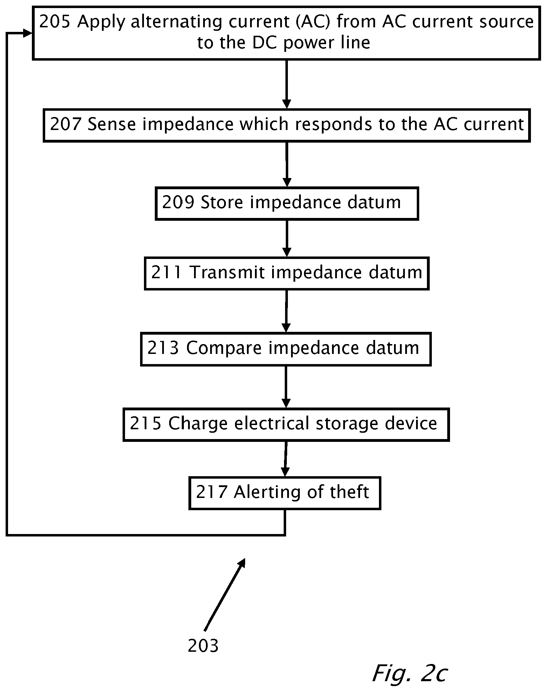

Reference is now also made to Figure 2c which shows a method **203** for theft detection of a power generation system **201** which illustrates pairing in system **201,** according to an embodiment of the present invention. An alternating current of typically 100 KHz is superimposed or applied (step **205**) onto DC line **216** for example via unit **212** and transformer $T_2$. Optionally, the coil of transformer $T_2$ connected in parallel with $C_2$ and $R_1$ have values selected to operate at a resonance with the series inductance of DC line **216** and inductor Li located in impedance unit **210**. During daylight operation of system **201** direct current flows out from panels **152** through Li and $D_1$ in impedance unit **210,** through receiver **104**, inverter **150**, source **260** and back to the other end of panels **152**. A measure of the impedance of panels **152** is achieved by sensing (step **207**) the current through inductor Li via amplifier $A_2$ and the voltage across diode $D_1$ via amplifier $A_3$. A measure of the impedance of panels **152** is achieved by dividing the magnitude of the voltage across diode $D_1$ by the magnitude of the current through inductor Li during sensing (step **207**). The measure of the impedance of panels **152** by sensing (step **207**) may be stored (step **209**) as an impedance datum in a memory (not shown) attached to amplifier $A_2$ and $A_3$ via analogue to digital (A/D) converters (not shown). The stored impedance datum derived by sensing (step **207**) may also be transmitted (step **211**) by transmitter **202** onto power lines **216**. Typically during night-time transmitter **202** transmits every 3 minutes. Receiver **204** receives the transmissions of the impedance datum from transmitter **202** via one side of transformer $T_1$. The other side of transformer $T_1$ is applied to the input of amplifier $A_1$. The output of amplifier $A_1$ is fed into the input of band-pass filter **224** which extracts the impedance data sent by transmitter **202**. The output of band-pass filter **224** is then converted to a digital value via analogue to digital (A/D) converter **222** which is optionally stored in processor **226** (with memory) operatively attached to the output of analogue to digital (A/D) converter **222**. Comparisons (step **213**) of stored impedance datum (step **209**) and transmitted impedance datum (step **211**) are preferably made by processor **226**. During daylight operation of capacitor $C_1$ serves as a charge storage device (step **215**) to optionally provide power to impedance unit **210** during night-time operation. A potential theft of a component of system **201** is alerted (step **217**) which is responsive to a change in the sensed impedance datum comparisons (step **213**) according to previously determined thresholds. A potential theft is alerted once there is no report from impedance unit **210** since transmitter **202** may transmit once in 3 minutes and if a transmission is not received then the cable may have been cut, in the case that power line communication is used.

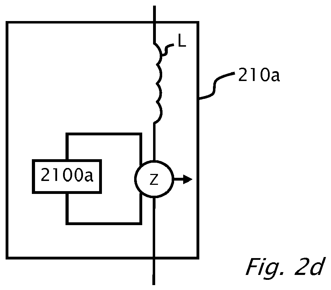

Reference is now made to Figure 2d which shows impedance unit **210a**, impedance unit **210a** is an alternative embodiment of impedance unit **210** shown in Figure 2b. Impedance unit **210a** includes a high impedance inductor **L**, possibly using resonance to increase impedance and an impedance meter **Z**. Inductor **L** is connected in series with impedance meter **Z**. Impedance meter **Z** may have a charge storage element **2100a** such as a battery or capacitor for nighttime operation which is charged during daytime operation. In another embodiment, impedance meter **Z** may be powered by the method of AC feed- The AC signal that is imposed on the inductor L is rectified when unit **212** includes an AC source used for the purpose of feeding power to probes **200** and for impedance measurement. Impedance meter **Z** is typically arranged to transmit impedance/ voltage/ current datum via power line communications or via a wireless connection or other suitable communications method.

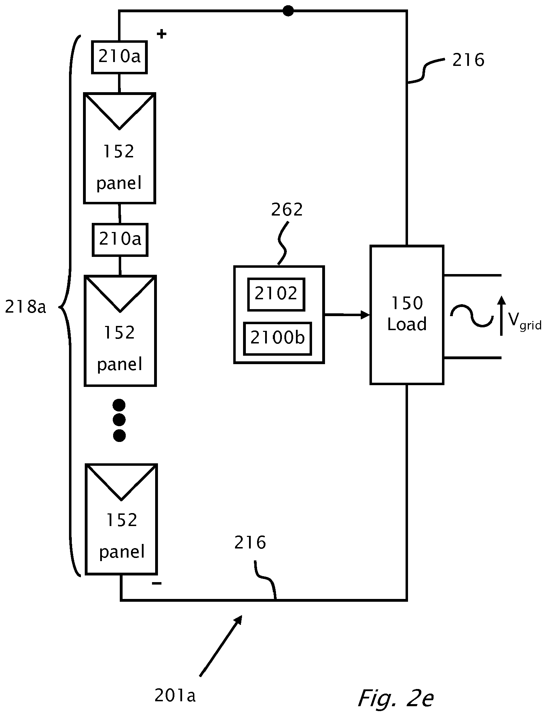

Reference is now made to Figure 2e which shows a power generation system **201a** including a theft prevention feature which illustrates pairing in system **201a** according to an embodiment of the present invention. Power generation system **201a** has a string **218a** of photovoltaic panels **152,** impedance units **210a**, a module **262** and load **150**. Load **150** may be a direct current (DC) to alternating current (AC) inverter with an output which connects to a grid voltage ($V_{grid}$). Impedance units **210a** are connected serially with panels **152** or may be incorporated as a part of a panel **152** to form string **218a**. Module **262** typically includes a receiver **2102** to receive datum transmitted from units **210a**.

During daytime operation module **262** may be powered by the voltage of string **218b**, by the grid voltage ($V_{grid}$)

during nighttime operation or module **262** may have a charge storage element **2100b** such as a battery or capacitor for nighttime operation which is charged during daytime operation. During nighttime operation, impedance units **210a** may be powered by module **262** (providing a typical 12 volts DC current to module **210a**) which is powered by the grid voltage ($V_{grid}$) and/or a charge storage device **2100b**. During daytime operation, impedance units **210a** may be powered by the current in string **218b** or by taking power from a single panel. Impedance units **210a** may have a charge storage element **2100a** such as a battery or capacitor for nighttime operation which is charged during daytime operation.

String **218a** is connected serially to the DC input of load **150** via direct current (DC) lines **216**. Module **262** may be incorporated as a part of the circuitry of load **150** or operatively attached to load **150**. Impedance units **210a** may sense the impedance of panels **152,** the current flowing in string **218a** or the voltage at a certain point within string **218a** depending where impedance unit **210a** is connected in string **218a**. Impedance unit **210a** periodically transmits a datum corresponding to the measured impedance/DC or AC current/DC or AC voltage datum over power line communications or via a wireless connection to module **262**. Module **262** alerts a potential theft of a component of system **201a** which is responsive to a change in the sensed impedance/ current/ voltage datum provided by impedance units **210a.** Not receiving a report is a potential theft on its own.

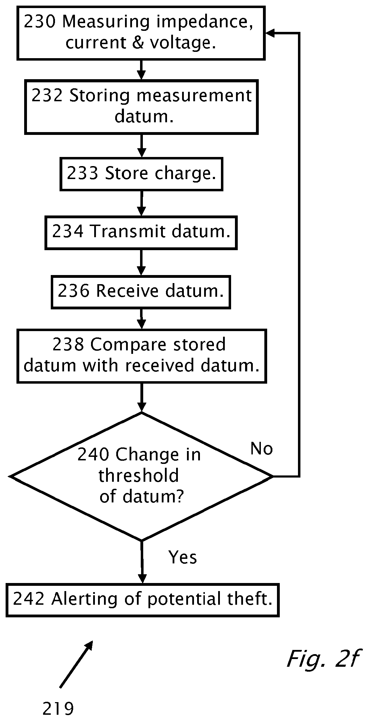

Reference is now made to Figure 2f which shows a method **219** for theft detection according to an embodiment of the present invention using system **201a** (shown in Figure 2e). Impedance units **210a** preferably measure impedance, DC current or DC voltage at various points in string **218a** (step **230**). Impedance units **210a** preferably have memories to store measured impedance, DC current or DC voltage as datum (step **232**). During daytime operation, impedance units **210a** may be powered by the current in string **218b**. Impedance units **210a** and/or module **262** may have a charge storage element (**2100a** and **2100b** respectively) such as a battery or capacitor for nighttime operation. The charge storage elements (**2100a** and **2100b** respectively) are used to store charge during daytime operation (step **233**). Impedance units **210a** transmit (step **234**) stored measurement datum (step **232**) by power line communications or via a wireless connection to module **262**. Module **262** receives the transmitted measurement datum with receiver **2102** and compares (step **238**) the transmitted datum with a datum that has been stored previously in a look-up table in module **262** as part of a process between module **262** and impedance units **210a.** If the comparison between stored datum (step **232**) and received datum (step **236**) is above a certain pre-defined threshold level, then module **262** may alert a potential theft of a component of system **201a** (step **242**), otherwise measurement of the impedance, DC current or DC voltage at various points in string **218a** (step **230**) continues. Not receiving a report in the central unit is a potential theft.

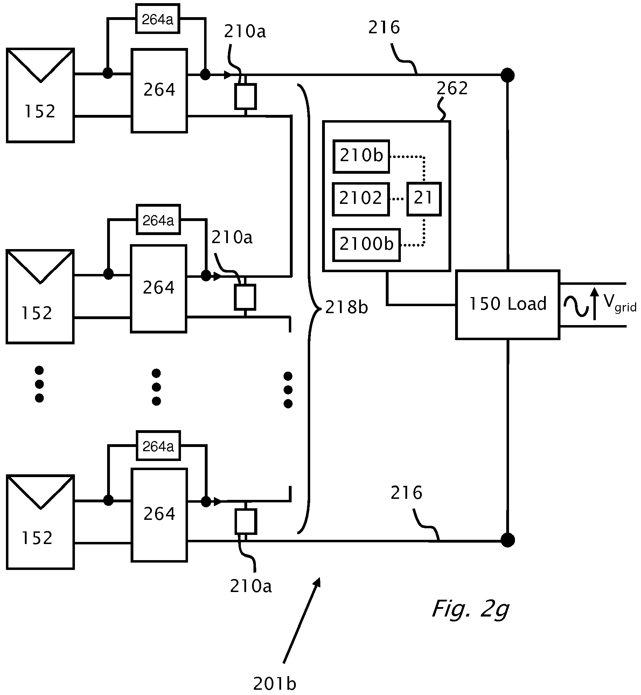

Reference is now made to Figure 2g which shows a power generation system **201b** including a theft prevention feature according to an embodiment of the present invention. Power generation system **201b** has a string **218b**, photovoltaic panels **152**, impedance units **210a**, electronic modules **264**, a module **262** and load **150**. Load **150** is preferably a direct current (DC) to alternating current (AC) inverter with an output which connects to a grid voltage ($V_{grid}$). The outputs impedance units **210a** are connected serially to form a string **218b**. The inputs of impedance units **210a** are connected to the outputs of electronic modules **264** either in parallel or in series. Impedance unit **210a** may be incorporated as a part of an electronic module **264**. The inputs of electronic modules **264** are connected to the outputs of panels **152**. Module **262** typically includes a receiver **2102** to receive datum transmitted from units **210a**. Electronic module **264** additionally includes a bypass **264a** which is connected serially between the input and output of module **264**. Bypass **264a** is a single pole switch which is energized to be open circuit when module **264** is receiving power from panel **152** or is a capacitor or a series capacitor and inductor.

During daytime operation module **262** may be powered by the voltage of string **218b**, by the grid voltage ($V_{grid}$) during nighttime operation or module **262** may have a charge storage element **2100b** such as a battery or capacitor for nighttime operation which is charged during daytime operation. During nighttime operation impedance units **210a** may be powered by module **262** (providing a typical 12 volts DC current) which is being powered by the grid voltage ($V_{grid}$) and/ or a charge storage device **2100b.** During daytime operation, impedance units **210a** may be powered by the voltage of module **264** or impedance units **210a** may have a charge storage element **2100a** such as a battery or capacitor for nighttime operation which is charged during daytime operation. There is an additional option for day and/or night operation for **210a** where module **262** sends an AC signal that is rectified by **210a** on some impedance (*e.g.* inductor in resonance) to produce DC.

String **218b** is connected serially to the DC input of load **150** via direct current (DC) lines **216**. Module **262** maybe optionally incorporated as a part of the circuitry of load **150** or operatively attached to load **150**. Impedance units **210a** preferably measures the impedance of modules **264,** the current flowing in string **218b** or the voltage at a certain point within string **218b** depending where an impedance unit **210a** is connected in string **218b** or the voltage output of a module **264**. Impedance unit **210a** periodically transmits datum corresponding to the measured impedance/ DC current/ DC voltage over power line communications or via a wireless connection to module **262**. Module **262** includes a receiver **2102** to receive datum from module **210a**. Module **262** alerts a potential theft of a component of system **201a** which is responsive to a change in the sensed impedance/ current/ voltage datum provided by impedance units **210a**. Again, theft can be detected by not getting a report from the impedance unit **210a** whether or not impedance unit **210a** is incorporated within modules **264**.

Impedance measurement may be performed by impedance unit **210a** alone or by using central impedance probe **210b** located in external AC source **262**, the latter method being appropriate for the case of simple panels with or without DC module **264**. Impedance probe is attached to microprocessor **21** which has ports for analogue to digital/ digital to analogue conversion and on board memory.

The impedance that is measured by impedance unit **210a** is actually the sum of impedances reflected by all other impedance units **210a**. Reference is now made to Figure 2d as an example of a circuit which may be included in impedance unit **210a**. Impedance unit **210a** may be part of DC module **264** and has the output capacitance of the DC module **264** and a series inductor (a regular inductor **L** or in resonance in order to increase its impedance. Another example is that impedance unit **210a** behaves as a capacitor (either as part of DC module 264 or separately) and the impedance measured is the impedance of the capacitor.

According to a feature of this embodiment, and other embodiments disclosed herein, is the ability to sense that photovoltaic panel **152** is no longer connected to DC module **264**, in case that only photovoltaic panel **152** is being stolen . During the day it is straightforward to detect a DC input from panel **152**. During the night, when panel **152** does not output DC, DC module **264** can measure the panel capacitance or try to impose a voltage and sense whether panel **152** draws current at some point (which is its diode voltage).

According to another feature of the present invention, where a panel **152** is attached to a module **264** and only a panel **152** is stolen at night; it is possible to configure module **264** to reflect passively the impedance of panel **152** by use of bypass **264a.**

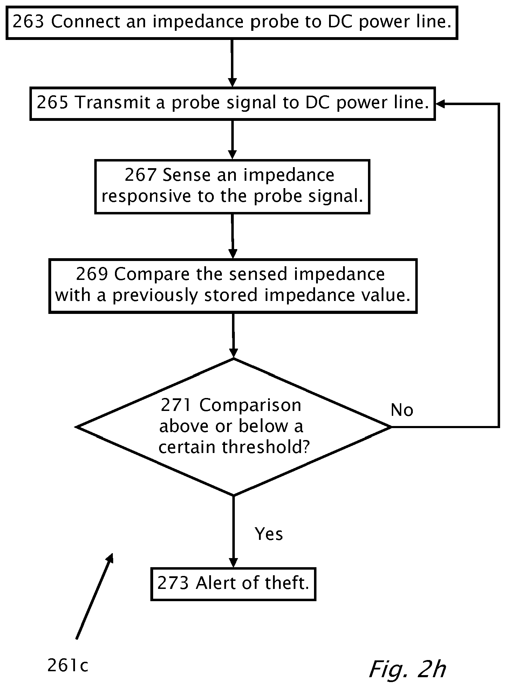

Reference is now made Figure 2h which shows a method **261c** of theft protection in a distributed electrical power generation system **201b,** according to an embodiment of the present invention. Central impedance probe **210b** is connected to DC line **216** (step **263**). Probe **210b** then transmits (step **265**) a probe signal onto DC line **216,** the probe signal may be an AC feed or a DC power line communication signal. Transmit step **265** is controlled and performed using microprocessor **21**. Probe **210b** then senses (step **267**) the impedance of string **218b** as a result of applying the probe signal. The sensed impedance in step **267** may then be compared (step **269**) with a previously stored impedance value stored in the memory of microprocessor **21**. The comparison may be to subtract the sensed impedance in step **267** from the previously stored impedance value stored in the memory of microprocessor **21** to produce a difference value. In decision box **271**, the difference value may then may be above or below a certain threshold value, in which case an alert of theft is made (step **273**), otherwise transmitting of the probe signal continues with step **265**.

In the case, in accordance with the invention, when bypass **264a** is a single pole switch (magnetic reed relay for example); during the night, when panel **152** does not output DC, the single pole switch is normally closed and the panel **152** impedance is bypassed from the input of module **264** to the output of module **264.** Typically if module **264** is a power converter circuit, the main switches in the power converter circuit are open circuit at night, so that the shunt impedance of the output and input of module **264** does not affect the measurement (step **267**) of the panel **152** impedance by probe **210b** (via bypass **264a**). During daytime operation the single pole switch **264a** is activated to be open circuit. Another preferable implementation for bypass **264a**, is to make bypass **264a** a fixed bypass between the input and output of the module **264**, were the fixed bypass **264a** reflects panel **152** impedance to the output of module **264** but will not interfere with the way module **264** works. The fixed bypass **264a** may be a series capacitor between the input and output of module **264** or a series capacitor and inductor between the input and output of module **264** which may be operated at resonance.

According to an aspect of the present invention there is provided a method which in preferred embodiments relies on impedance measurement performed by a central unit (load/inverter) by sending a signal and measuring voltage/current. In one example, the signal is a dedicated measurement signal. In this case, impedance/capacitance of panels **152** without any additional circuitry may be sensed. In another example, the signal is an AC feed for power modules **264** (during the night or day). In another example, the signal is a power-line-communication that may be used for other purposes (such as command and control, monitoring etc.). The additional circuitry, *e.g.* power modules **264** may reflect an impedance or output capacitance to measure. Alternatively, the impedance of a series inductor (e.g. regular, resonance, switched resonance) of DC module **264** is measured by command and control from the central unit).

Reference is now made again to Figure 2f which shows a method **219** for theft detection according to an embodiment of the present invention using system **201b** shown in Figure 2g. Impedance units **210a** preferably measures impedance, DC current or DC voltage at various points in string **218b** (step **230**). Impedance units **210a** preferably have memories to store measured impedance, DC or AC current or DC or AC voltage as datum (step **232**). During daytime operation, impedance units **210a** may be powered by the output voltages of modules **264** or impedance units **210a** and module **262** may optionally have a charge storage element **2100b** such as a battery or capacitor which is used during nighttime operation. The charge storage elements (**2100a** and **2100b**) are used to store charge during daytime operation (step **233**). Impedance units **210a** transmit the measurement datum (step **234**) by power line communications or via a wireless connection to module **262**. Module **262** receives the transmitted measurement datum with receiver **2102** and compares (step **238**) the transmitted datum with datum that has been stored previously in a look table in module **262** as part of a process between module **262** and impedance units **210a**. If the comparison of datum is above a certain pre-defined level module **262** alerts a potential theft of a component of system **201a** (step **242**), otherwise measurement of the impedance, DC current or DC voltage at various points in string **218a** (step **230**) continues.

**Thermal Camera**

Infrared (IR) radiation or heat radiation is herein defined as electromagnetic radiation whose wavelength is longer than that of visible light (400-700 nm), but shorter than that of terahertz radiation (100 $\mu$m-1 mm) and microwaves.

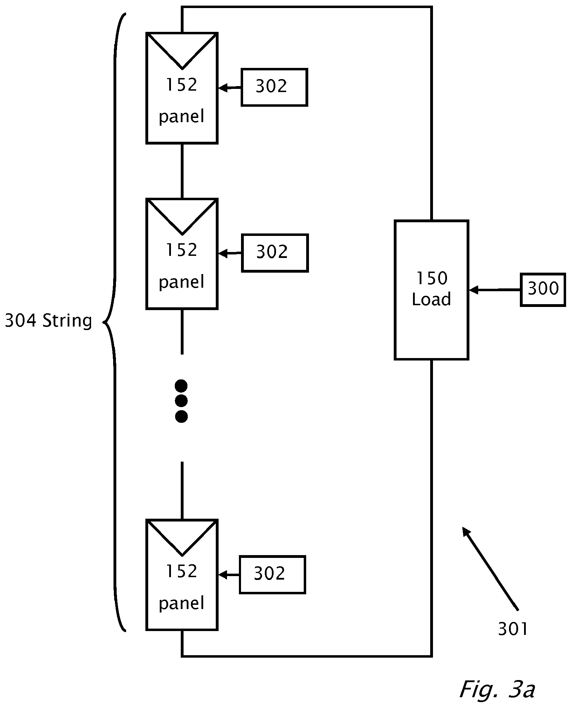

Reference is now made to Figure 3a which shows a power generation system **301** including a theft prevention feature according to an embodiment of the present invention. An electronic module **302** is operatively attached to a photovoltaic panel **152**. Electronic module **302** may perform direct current to direct current (DC/DC) conversion or DC to alternating current (AC) inverter and according to an embodiment of the present invention is capable of reverse biasing a panel **152**. Multiple panels **152** are connected in series to form a string **304**. Load **150** may be a direct current (DC) to alternating current (AC) inverter. A central control unit **300** preferably located in the vicinity of load **150** is operatively connected to load **150** and electronic module **302**. Central control unit **300** optionally provides a signal to electronic module **302** as well as being connected to a camera **306** (not shown). The signal from central controller **300** to electronic module **302** may be conveyed over the power lines connecting load **150** to string **304** or via a wireless connection between controller **300** and module **302**.

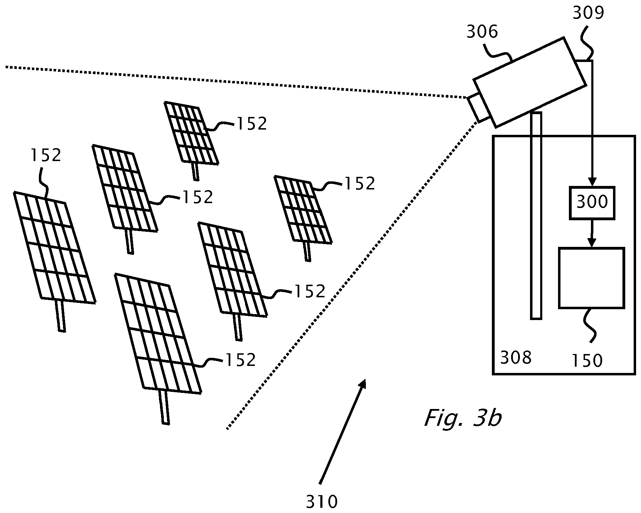

Reference is now made to Figure 3b which shows a typical topography **310** of power generation system **301** (shown in Figure 3a) including a theft prevention feature according to an embodiment of the present invention. Topography **310** includes multiple panels **152** with modules **302** (not shown) which are connected to load **150** and controller **300**. A camera **306** is located in the vicinity of controller **300** and load **150** which are located in a building **308**. Camera **306** is preferably a thermal imaging camera. The field of view of camera **306** preferably captures images of panels **152**. The captured images of panels **152** by camera **306** are preferably sent to controller **300** for analysis via power/ signal line **309** or via wireless communications.

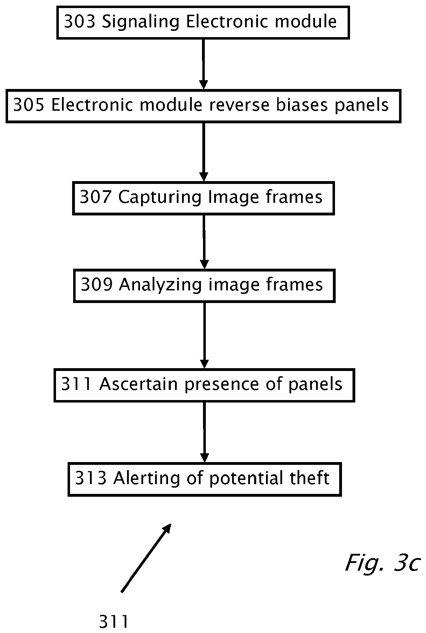

Reference is now also made to Figure 3c which shows a method **311** for theft detection according to an embodiment of the present invention using system **301** with topography **310**. During theft detection a signal is sent from central unit **300** to an electronic module **302** (step **303**). The signal from unit **300** to electronic module **302** may be conveyed over the power lines connecting load **150** to string **304** or via a wireless connection or other communications method between unit **300** and module **302**. Typically the signal sent from unit **300** reverse biases panel **152** via module **302** (step **305**) for a period of time which causes a noticeable rise in panel **152** temperature. After reverse biasing panels **152** (step **305**) using module **302**, image frames of panels **152** are captured using camera **306** (step **307**). Unit **300** then analyzes (step **309**) the image frames of panels **152** captured by camera **306** (step **307**). Analyzing the captured image frames preferably means monitoring the effects of reverse biasing panels **152** or alternatively monitoring the thermal effects of normal current flow produced during daylight operation of panels **152** without the use of the signal sent from unit **300**. Reverse biasing panels using the signal from unit **300** has the effect of heating up panels **152** thereby altering the infrared radiation/ heat radiation of panels **152**. The presence of panels **152** is ascertained (step **311**) by virtue of the infrared radiation change analyzed by unit **300** in captured image frames, after a signal from unit **300** is applied to a panel **152** via module **302**. The alerting of a potential theft (step **313**) is therefore achieved by the absence of panel **152** not providing a thermal change as a result of applying a signal to a panel **152** via module **302**.

**Wireless Communications**

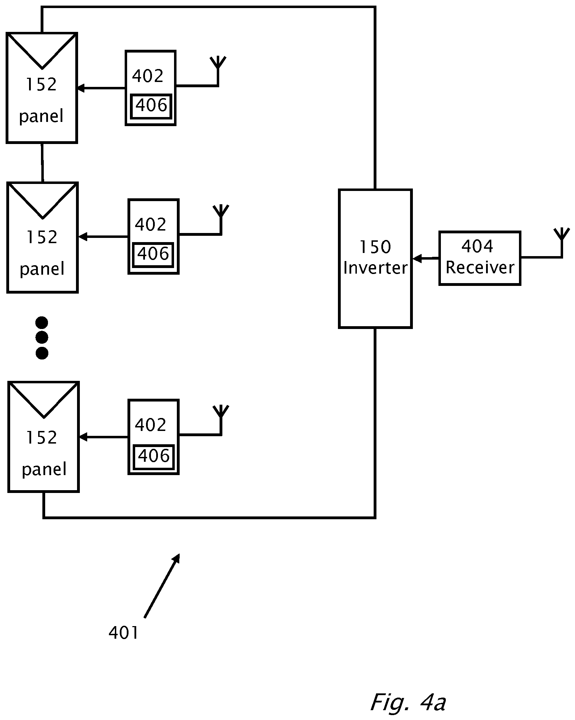

Reference is now made to Figure 4a which shows a power generation system **401** including a theft prevention feature according to an embodiment of the present invention. Photovoltaic panels **152** have transmitters **402** operatively attached thereto. Transmitter **402** preferably has a charge storage device **406** used to power transmitter **402** during the nighttime. The charge storage device **406** of transmitter **402** is charged during normal daylight by electricity generated by irradiation of panels **152**. Multiple panels **152** are connected in series to a load **150**. Load **150** is preferably a direct current (DC) to alternating current (AC) inverter. Attached to and in the vicinity of load **150** is a receiver **404**. Receiver **404** receives signals from transmitters **402**. Receiver **401** may be composed of an array of receivers/repeaters spread in the solar field installations which eventually send all received information to inverter **150**.

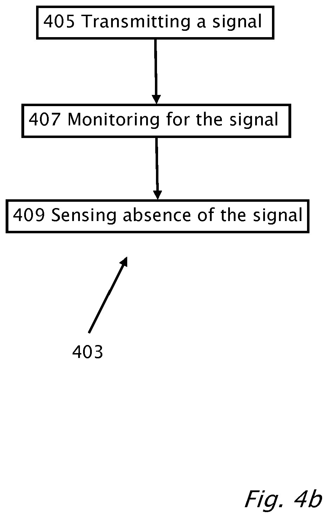

Reference is now also made to Figure 4b which shows a method **403** for theft prevention using system **401**, the method **403** is according to an embodiment of the present invention. Transmitters **402** operatively attached to panels **152** transmit signals (step **405**). The transmitted signals of transmitters **402** are preferably transmitted each on different frequencies. The different frequencies that transmitters **402** transmit allow for the unique identification of a particular panel **152**. The transmitted signals of transmitters **402** are monitored (step **407**) by receiver **404**. The monitoring (step **407**) by receiver **404** preferably allows for differentiation and identification of which transmitter **402** is transmitting. The absence of a signal from a transmitter is preferably sensed (step **409**) by receiver **404**. Receiver **404** preferably alerts the situation a theft by virtue of an absence of a received signal or signals from transmitters **402**.

In an additional method, transmitter **402** sends a signal only upon theft (detected by either specific sensors like accelerometers or by disconnection from the cable which cuts off signaling or DC feeding from inverter **150**.

In an additional implementation, transmitter **402** is passive and contains only a resonance circuit (in series/parallel) and an antenna. Inverter **150** sends an AC signal via the cable that is transmitted passively by the antenna of **402** and is amplified by the resonance circuit of **402**. An advantage is that there is no need to feed anything during the night, besides sending a signal on the cable.

Another variant of this method is where photovoltaic panels include a module with a resonance circuit in a different frequency band such that load **150** sends all the relevant frequencies (e.g. a frequency sweep) and receiver **402** senses occurrence of frequency dips, a dip is a specific indication of a stolen module. It gives both identification and additional accuracy (since the received strength signal is not summed over all modules).

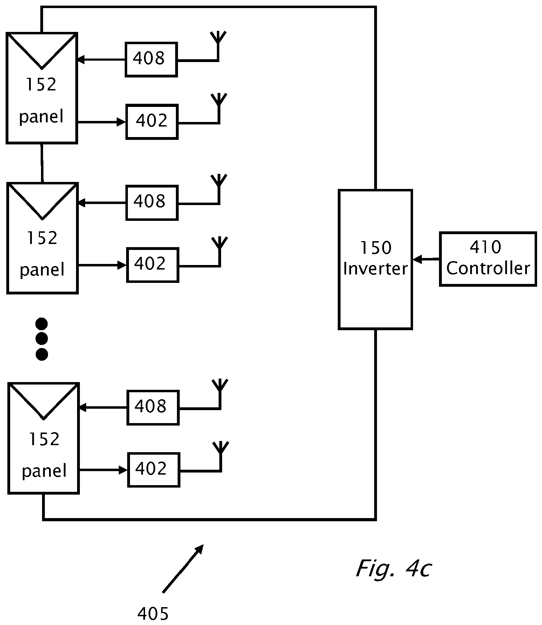

Reference is now made to Figure 4c which shows a power generation system **405** including a theft prevention feature according to an embodiment of the present invention. Multiple photovoltaic panels **152** are connected in series to form a string. The string of photovoltaic panels **152** are connected across a load **150**. Load **150** is preferably a direct current (DC) to alternating current (AC) inverter. Operatively attached to each panel **152** are a transmitter **402** and a receiver **408**. The transmitter **402** and receiver **408** may share common components and may be unified into a transceiver. A central control unit **410** is operatively attached to a transmitter **402** and a receiver **408** via load **150**. Control unit **706** may be operatively attached to transmitter **402** and a receiver **408** via power line communications or via a wireless connection. Receiver **408** optionally receives a signal from transmitter **402**.

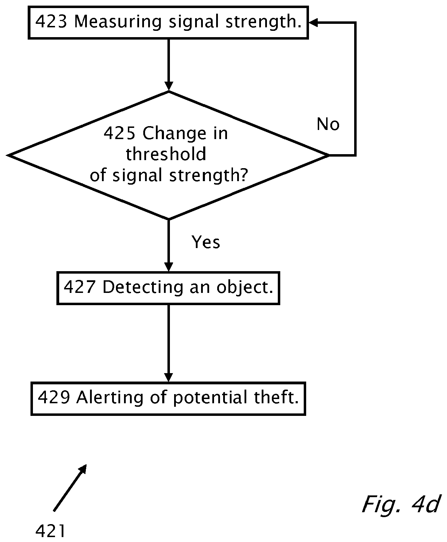

Reference is now made to Figure 4d which shows a method **421** for theft detection/prevention according to an embodiment of the present invention. Receiver **408** measures the signal strength (step **423**) of transmitters **402** within in the immediate vicinity of panel **152**. A change in signal strength measured in the immediate vicinity of panel **152** according to a predetermined threshold (step **425**) is used to detect (step **427**) an object in the immediate vicinity of panel **152**. The change in signal strength detected by receiver **408** is conveyed to central controller **410** which provides an alert of a potential theft of panel **152** (step **429**). If there is no significant change in threshold signal strength (step **425**) receiver **408** continues to measures the signal strength (step **423**) of transmitters **402** within in the immediate vicinity of panel **152**.

**Electric field strength measurement**

The term "electric field" as used herein refers to the electric flux present in the space surrounding an electric charge or the electric flux present in the space of a time-varying magnetic field. The space surrounding an electric charge or the space in the presence of a time-varying magnetic field may be air and / or a dielectric material. The electric field exerts a force on other electrically charged objects with the magnitude of the force dependent on the inverse square relationship of the distance between electrically charged objects.

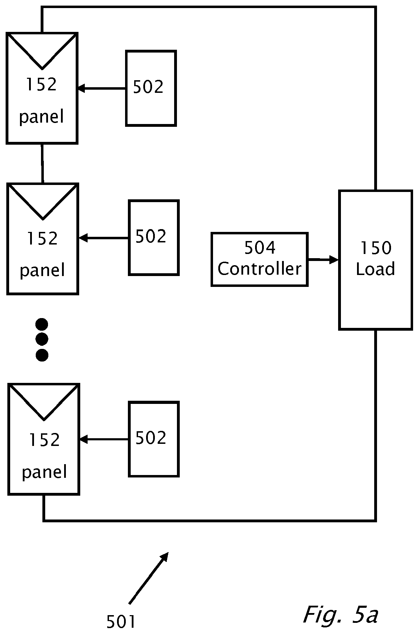

Reference is now made to Figure 5a which shows a power generation system **501** including a theft prevention feature according to an embodiment of the present invention. Multiple photovoltaic panels **152** are connected in series to form a string. The string of photovoltaic panels **152** are connected across a load **150**. Load **150** is preferably a direct current (DC) to alternating current (AC) inverter. Operatively attached to each panel **152** is a field sensor **502**. Field sensor **502** typically measures the electric field within panel **152** or in the electric field in the immediate vicinity of panel **152**. Operatively attached to sensors **502** is a controller **504** which is also operatively attached to load **150**.

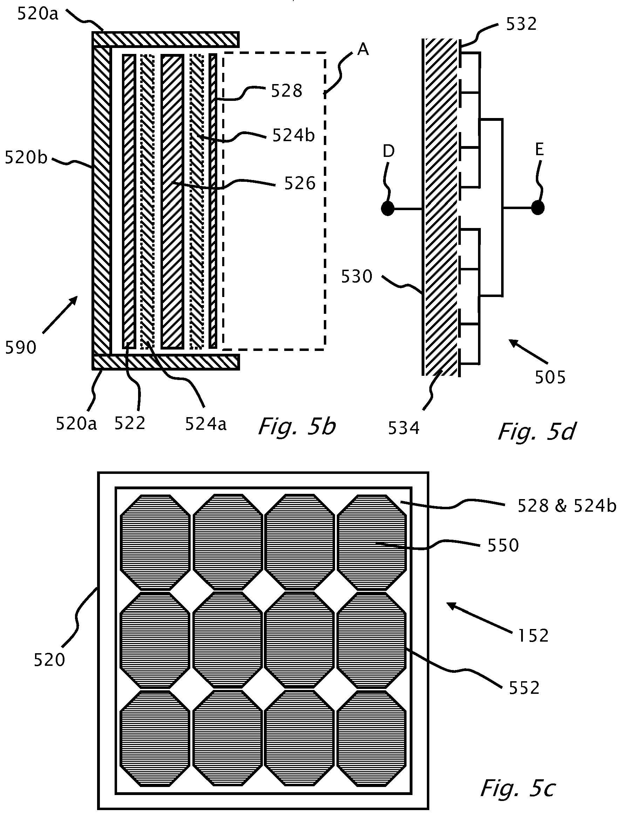

Reference is now made to Figure 5b which shows a typical cross-section **590** of photovoltaic panel **152**. Cross-section **590** shows typical parts **520a, 520b, 522, 524a, 534b, 526** and **528** which may be included in a photovoltaic panel **152**. Parts **522, 524a, 534b, 526** and **528** are located in a casing **520** formed by parts **520a** (typically a metal alloy) and **520b** (typically a metal alloy or a plastic type of material) is used to house an insulating sheet **522**. Next to insulating sheet **522** is a reactive encapsulant sheet **524a** which is typically made from ethylene vinyl acetate polymer. Next to reactive encapsulant sheet **524a** is photovoltaic substrate **526** followed by another reactive encapsulant sheet **524b**. Finally after reactive encapsulant sheet **524b** is a sheet typically of low iron flat glass **528**. The side of photovoltaic substrate **526** adjacent to reactive encapsulant sheet **524b** is where the metal tracks **550** (not shown) are which connect electrically the photovoltaic cells **552** (not shown) of photovoltaic substrate **526**. Sensor **502** may be placed between photovoltaic substrate **526** and reactive encapsulant sheet **524a** or in area **A**.

Reference is now made to Figure 5c which shows a plan view photovoltaic panel **152**. The plan view shows casing **520** and photovoltaic cells **552** with tracks **550** showing through transparent glass **528** and sheet **524b**.

Reference is now also made to Figure 5d which shows an equivalent capacitor **505** representing photovoltaic panel **152**. Plate **530** and node **D** equivalently represent the casing **520** of panel **152**. Dielectric **534** represents collectively; insulating sheet **522,** reactive encapsulant sheets **524b/ 524a**, photovoltaic substrate **526,** low iron flat glass **528** and the air space shown by area **A** in figure 5b. Plates **532** with node **E** represent the metal track deposit **550** which connects electrically the photovoltaic cells **552** shown in Figure 5c of photovoltaic substrate **526**. The capacitance (C) in farads of capacitor **505** is given by equation Eq. 1

$$C = \frac{\varepsilon_0 \varepsilon_r X}{d} \qquad\qquad \text{Eq.1}$$

with $\varepsilon_o$ = permittivity of free space = 8.85 X $10^{-12}$ farads per meter, $\varepsilon_r$ = relative permittivity or dielectric constant of dielectric **534**, $X$ = the area of plates **530** and **532** and $d$ = the distance between plates **530** and **532**. An object in the vicinity of area **A** causes the dielectric constant ($\varepsilon_r$) to vary since the air space shown by area **A** in figure 5b makes up part of the dielectric constant ($\varepsilon_r$), hence the capacitance (C) varies and hence the electric field (E) varies in capacitor **505**.

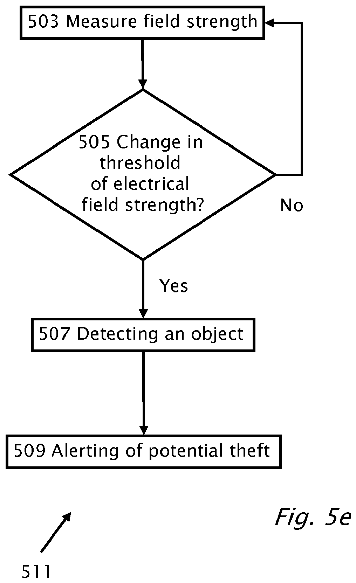

Reference is now also made to Figure 5e which shows a method **511** for theft detection/prevention according to an embodiment of the present invention using equivalent capacitor **505**. Sensor **502** measures the electric field strength (step **503**) within panel **152** or in the electric field in the immediate vicinity of panel **152** i.e. area **A.** A change in the electric field strength measured field in the immediate vicinity of panel **152** or in panel **152** according to a predetermined threshold (step **505**) is used to detect (step **507**) an object in the immediate vicinity of panel **152**. The change in electric field strength detected by sensor **502** is conveyed to central controller **504** which provides an alert of a potential theft of panel **152** (step **509**). If there is no significant change in threshold of electric field strength (step **505**) sensor **502** continues to measures the electric field strength (step **503**).

### Reflectometry from within a string

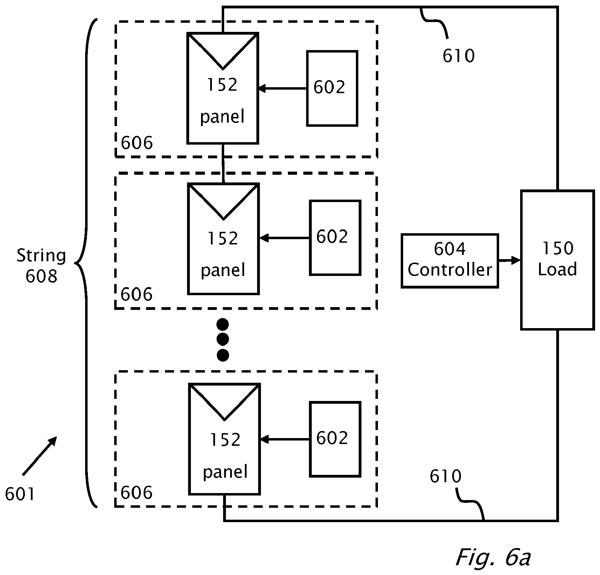

Reference is now made to Figure 6a which shows a power generation system **601** including a theft prevention feature according to an embodiment of the present invention. Multiple photovoltaic modules **606** are connected in series to form a photovoltaic string **608**. Photovoltaic string **608** is connected across a load **150** via direct current (DC) power lines **610**. Load **150** is preferably a direct current (DC) to alternating current (AC) inverter. Photovoltaic modules **606** have a photovoltaic panel **152** which is operatively attached to switch unit **602**. A central control unit **604** is operatively attached to load **150** and typically provides a control signal and a test signal which are superimposed onto power lines **610** via load **150**. Switch unit **602** optionally receives the control signal from unit **604** and in response to the control signal from unit **604;** switch unit **602** typically reconfigures the connection of panel **152** to load **150** by adding a resonant circuit in either series or parallel with panel **152.**

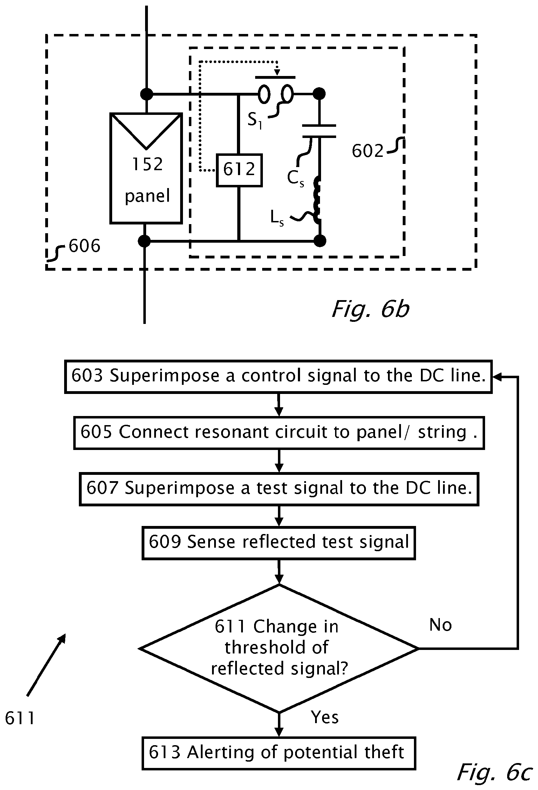

Reference is now made to Figure 6b which shows further details of photovoltaic module **606** according to an embodiment of the present invention. Photovoltaic module **606** typically has switch unit **602** connected across in parallel with a panel **152,** in series with a string of panels or switch unit **602** may be connected across a string of panels **152**. Multiple switch units may be activated independently. Switch unit **602** is operatively attached to controller **604** and in the case of switch unit **602** connected in parallel with module **606**, switch unit **602** preferably has a switch $S_1$ connected in series with a capacitor $C_s$ and inductor $L_s$. Switch $S_1$ is activated by actuator **612** with actuator **612** deriving power from connection across panel **152** as well as the control signal from central control unit **604** to close switch $S_1$. The power that actuator **612** derives from panel **152** additionally charges a storage device such as a battery located in actuator **612** to allow for nighttime operation of switch unit **602**. Multiple switch units **602** may be activated/ de-activated independently.

Figures 6b shows that the resonant circuit is connected in parallel to panel **152.** Alternatively, the resonant circuit may be in series to panel **152** (with the resonance circuit being a parallel LC instead of a series LC).

The need for switching the resonance circuit is not mandatory and might be not available if actuator **612** does not have power for doing so. Reflectometry may be measured even if the resonance circuit is always connected (either in series or in parallel). However, the reason for adding this resonance switching is in order to command each string to either activate or not activate the resonance. That way, it is possible to control (via central unit, *e.g* load **150** in this case) which strings participate in the reflectometry measurement. Specifically, it would be preferable to have only one string participating at a time which can provide good accuracy for the measurement (meaning that all the other strings will have their resonance switched off).

Reference is now made to Figure 6c which shows a method **611** for theft detection/prevention using system **601** according to an embodiment of the present invention. A control signal is superimposed onto power lines **610** by controller **604** (step **603**). The control signal superimposed onto power lines **610** by controller **604** causes switch $S_1$ to close in switch unit **602.** Switch $S_1$ in closing switch unit **602** cause series resonant circuit capacitor $C_s$ and inductor $L_s$ to be connected across panel **152** (step **605**). Typically switch $S_1$ closes for a predetermined time period. With $S_1$ closed a test signal is superimposed onto power lines **610** by controller **604** (step **607**). The test signal controller **604** superimposes onto power lines **610** may be a time division reflectometry (TDR) signal or a frequency division reflectometry signal (FDR). The test signal preferably resonates with series capacitor $C_s$ and inductor $L_s$. Series capacitor $C_s$ and inductor $L_s$ have values chosen to give a narrow band circuit of typically 15-25MHz. Controller **604** then senses (step **609**) the reflected TDR or FDR signal on power lines **610**. If a change in sense threshold of reflected test signal is detected **(step 611)** an alerting of potential theft may be made (step **613**) otherwise theft detection continues again with step **603.**

**Mesh Network**

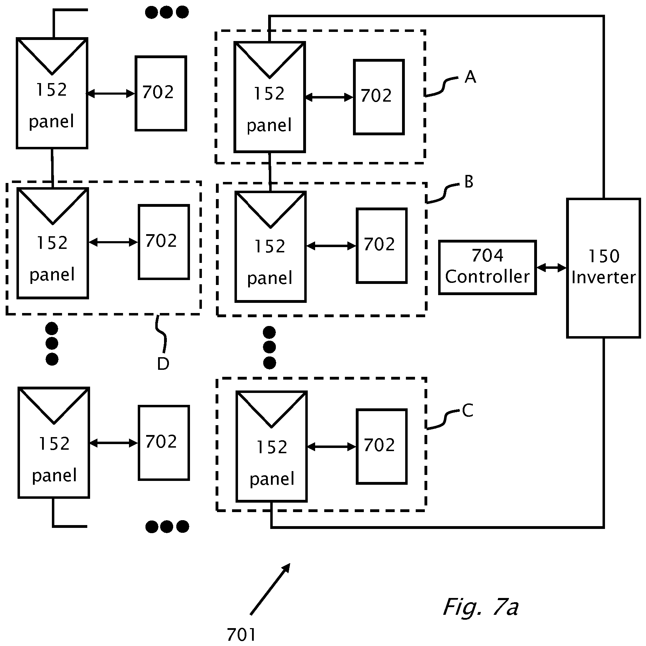

Reference is now made to Figure 7a which shows a power generation system **701** including a theft prevention feature according to an embodiment of the present invention. Multiple photovoltaic panels **152** are connected in series to form a string. The string of photovoltaic panels **152** are connected across a load **150.** Multiple strings are then also connected in parallel. Load **150** is preferably a direct current (DC) to alternating current (AC) inverter. Attached to each panel **152** is an electronic module **702.** Module **702** typically receives a data signal from controller **704** via wireless or power line communications. For example, the data signal that panel module **B** receives from controller **704** typically requests panel module **B** to provide details of other panel modules in the immediate vicinity of panel module **B.** The panel modules in the immediate vicinity of panel **B** are panel modules **A**, **C** and **D**. A panel module typically collects data of other panel modules in the immediate vicinity and sends a data signal back to controller **704** via wireless communication or through the power lines connecting panels **152** to load **150.**

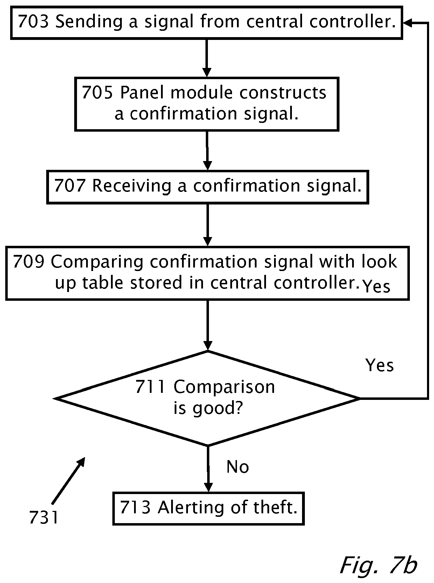

Reference is now made to Figure 7b which shows a method **731** for theft detection/ prevention according to an embodiment of the present invention. Typically at the installation or upgrade of power generation system **701**, details of system **701** in terms of electrical connection and/ or topological layout of panels **152** in system **701** is programmed in a look up table in controller **704.** Using panel module **B** as an exemplary embodiment of the present invention, controller **704** typically sends (step **703**) a signal to panel module **B** via wireless communication or through the power lines connecting panels **152** to load **150.** The signal sent from controller **704** to panel module **B** causes panel module **B** to construct a confirmation signal based on the signal sent from controller **704** (step **705**). The constructed confirmation typically includes information about panel module **B** and according to a feature of the preferred embodiments, information that panel module **B** collects from panel modules **A**, **C** and **D** which are in the immediate vicinity of panel module **B.** Panel module **B** transmits the confirmation signal via wireless communication or through the power lines connecting panels **152** to load **150** where the confirmation signal is received by controller **704** (step **707**). Controller **704** then compares the received confirmation signal with the look up table stored in controller **704** (step **709**). If the comparison is good (step **711**), theft detection continues by sending a signal from central controller **704** (step **703**) otherwise a potential alert of theft of a panel and/ or panels **152** is made (step **713**).

In another embodiment, probe signal (step **703**) and confirmation signal (step **705)** may not be required. Instead, each module **702** may be programmed to send a message periodically towards its neighbors, every three minutes for instance. The message when received is first of all a message that says transmitting module **702** is alive and can also measure data, *e.g* impedance and transmit data. The transmitted message is received by neighboring modules **702** and the transmission propagates along the mesh network until the transmission reaches controller **704** typically at the site of the load/inverter/main-receiver.

The definite articles "a", "an" is used herein, such as "a converter", "a switch" have the meaning of "one or more" that is "one or more converters" or "one or more switches".

While the invention has been described with respect to a limited number of embodiments, it will be appreciated that many variations, modifications and other applications of the invention as defined in the appended claims may be made.

It is to be understood that although there are described herein different embodiments, the features of the various embodiments could be combined together, in any combination preferred by the skilled person. So doing can, for instance, provide a system with two or more theft prevention/detection devices.

**Claims**

**1.** An apparatus (152, 264, 210a, 264a) comprising:

a photovoltaic direct current power source (152);
an electronic module (264) comprising an input and an output, wherein the input is connected to the photovoltaic direct current power source;
an impedance unit (210a) configured to sense an impedance, a current, or a voltage at the output of the electronic module;
wherein the electronic module (264) further comprises a bypass (264a) connected between the input and the output of the electronic module, wherein the bypass is a single pole switch which is configured to be open circuit when the electronic module is receiving power from the photovoltaic direct current power source.

**2.** The apparatus of claim 1, wherein the electronic module (264) further comprises a power converter circuit.

3. The apparatus of any preceding claim, further comprising an alternating current source, wherein the alternating current source is arranged to superimpose an alternating current onto a power line (216) connected to the output of the electronic module (264), wherein the impedance of the photovoltaic direct current power source (152) is responsive to the alternating current.

4. The apparatus of claim 3, wherein the impedance unit (210a) is operatively attached to the power line (216).

5. The apparatus of any preceding claim, wherein the impedance unit (210a) is located at the output of, or incorporated as part of, the electronic module (264).

6. The apparatus of any preceding claim, wherein, when the electronic module (264) is not receiving power from the photovoltaic direct current power source (152), main switches in the power converter circuit are open circuit such that a shunt impedance of the output and the input of the electronic module does not affect a measurement of the impedance of the photovoltaic direct current power source (152).

7. The apparatus of any preceding claim, comprising:
a microprocessor (21) that compares the impedance of the photovoltaic direct current power source with a previous impedance value stored in a memory to produce a difference value, and makes an alert if the difference value is above or below a certain threshold value.

8. The apparatus of any preceding claim, further comprising:

a plurality of photovoltaic direct current power sources (152);
a plurality of electronic modules (264), each of the plurality of electronic modules (264) having an input connected to a respective one of the plurality of photovoltaic direct current power sources (152), and each of the plurality of electronic modules (264) having an output connected in a serial string (218b) connected to a power line (216); and
a plurality of bypasses (264a), each of the plurality of bypasses (264a) connected between the input and the output of a respective one of the plurality of electronic modules (264) and adapted to bypass an impedance of the respective one of the plurality photovoltaic direct current power source (152) connected to the input of the respective one of the plurality electronic modules (264) to the output of the respective one of the plurality of electronic modules (264).

9. A method for operating an apparatus according to any one of claims 1-8, the method comprising:

bypassing, from the input to the output of the electronic module (264) using the bypass (264a), the impedance of the photovoltaic direct current power source (152);
sensing, with the impedance unit (210a, 210b), the impedance, a current, or a voltage at the output of the electronic module (264); and
detecting a change in the impedance, the current, or the voltage at the output of the electronic module (264) greater than a previously determined threshold.

10. The method of claim 9, comprising the step of:
alerting a potential theft of the photovoltaic direct current power source (152) responsive to the change in the impedance, the current, or the voltage greater than a previously determined threshold.

11. The method of any one of claims 9 -10, wherein powering the impedance unit by one of: a current of the photovoltaic direct current power source, a power received from a photovoltaic panel, or a charge storage element.

12. The method of any one of claims 9-11, wherein the electronic module (264) comprises the power converter circuit, and wherein the method further comprises:
opening main switches in the power converter circuit such that a shunt impedance of at least one of the output and the input of the electronic module does not affect a measurement of the impedance of the photovoltaic direct current power source (152).

**Patentansprüche**

1. Vorrichtung (152, 264, 210a, 264a), umfassend:

   eine photovoltaische Gleichstromquelle (152);
   ein elektronisches Modul (264), das einen Eingang und einen Ausgang umfasst, wobei der Eingang mit der photovoltaischen Gleichstromquelle verbunden ist;
   eine Impedanzeinheit (210a), die dazu konfiguriert ist, eine Impedanz, eine Stromstärke oder eine Spannung am Ausgang des elektronischen Moduls zu erfassen;
   wobei das elektronische Modul (264) ferner eine Umgehung (264a) umfasst, die zwischen den Eingang und den Ausgang des elektronischen Moduls geschaltet ist, wobei die Umgehung ein einpoliger Schalter ist, der dazu konfiguriert ist, geöffnet zu sein, wenn das elektronische Modul Strom von der photovoltaischen Gleichstromquelle empfängt.

2. Vorrichtung gemäß Anspruch 1, wobei das elektronische Modul (264) ferner eine Stromrichterschaltung umfasst.

3. Vorrichtung gemäß einem der vorhergehenden Ansprüche, ferner umfassend eine Wechselstromquelle, wobei die Wechselstromquelle dazu angeordnet ist, einen Wechselstrom auf einer Stromleitung (216), die mit dem Ausgang des elektronischen Moduls (264) verbunden ist, zu überlagern, wobei die Impedanz der photovoltaischen Gleichstromquelle (152) auf den Wechselstrom anspricht.

4. Vorrichtung gemäß Anspruch 3, wobei die Impedanzeinheit (210a) mit der Stromleitung (216) wirksam verbunden ist.

5. Vorrichtung gemäß einem der vorhergehenden Ansprüche, wobei die Impedanzeinheit (210a) an dem Ausgang des elektronischen Moduls (264) angeordnet oder als Teil von diesem in dieses integriert ist.

6. Vorrichtung gemäß einem der vorhergehenden Ansprüche, wobei, wenn das elektronische Modul (264) keine Leistung von der photovoltaischen Gleichstromquelle (152) empfängt, Hauptschalter in der Stromrichterschaltung geöffnet sind, sodass sich eine Parallelimpedanz des Ausgangs und des Eingangs des elektronischen Moduls nicht auf eine Messung der Impedanz der photovoltaischen Gleichstromquelle (152) auswirkt.

7. Vorrichtung gemäß einem der vorhergehenden Ansprüche, umfassend:
   einen Mikroprozessor (21), der die Impedanz der photovoltaischen Gleichstromquelle mit einem vorhergehenden Impedanzwert vergleicht, der in einem Speicher gespeichert ist, um einen Differenzwert zu erzeugen, und einen Alarm ausgibt, wenn der Differenzwert über oder unter einem bestimmten Schwellenwert liegt.

8. Vorrichtung gemäß einem der vorhergehenden Ansprüche, ferner umfassend:

   eine Mehrzahl photovoltaischer Gleichstromquellen (152);
   eine Mehrzahl elektronischer Module (264), wobei jedes der Mehrzahl elektronischer Module (264) einen Eingang hat, der mit einer jeweiligen der Mehrzahl an photovoltaischen Gleichstromquellen (152) verbunden ist, und jedes der Mehrzahl elektronischer Module (264) einen Ausgang hat, der in einem seriellen String (218b) verbunden ist, der mit einer Stromleitung (216) verbunden ist; und
   eine Mehrzahl von Umgehungen (264a), wobei jede der Mehrzahl von Umgehungen (264a) zwischen den Eingang und den Ausgang einer jeweiligen der Mehrzahl elektronischer Module (264) geschaltet und dazu angepasst ist, eine Impedanz der jeweiligen der Mehrzahl photovoltaischer Gleichstromquellen (152), die mit dem Eingang der jeweiligen der Mehrzahl der elektronischen Module (264) verbunden sind, zu dem Ausgang der jeweiligen der Mehrzahl elektronischer Module (264) zu umgehen.

9. Verfahren zum Betreiben einer Vorrichtung gemäß einem der Ansprüche 1 bis 8, wobei das Verfahren umfasst:

   Umgehen der Impedanz der photovoltaischen Gleichstromquelle (152) von dem Eingang zu dem Ausgang des elektronischen Moduls (264) unter der Verwendung der Umgehung (264a);
   Erfassen der Impedanz, einer Stromstärke oder einer Spannung des elektronischen Moduls (264) mit der Impedanzeinheit (210a, 210b); und
   Feststellen einer Veränderung der Impedanz, der Stromstärke oder der Spannung am Ausgang des elektronischen Moduls (264), die größer als ein im Voraus bestimmter Schwellenwert ist.

**10.** Verfahren gemäß Anspruch 9, umfassend den folgenden Schritt:
Anzeigen eines potentiellen Diebstahls der photovoltaischen Gleichstromquelle (152) in Reaktion auf die Veränderung der Impedanz, der Stromstärke oder der Spannung, die größer als ein im Voraus bestimmter Schwellenwert ist.

**11.** Verfahren gemäß einem der Ansprüche 9 bis 10, wobei das Bestromen der Impedanzeinheit durch eines aus den Folgenden erfolgt: einen Strom der photovoltaischen Gleichstromquelle, eine von einem photovoltaischen Panel empfangene Leistung oder ein Ladungsspeicherelement.

**12.** Verfahren gemäß einem der Ansprüche 9 bis 11, wobei das elektronische Modul (264) die Stromrichterschaltung umfasst und wobei das Verfahren ferner umfasst:
Öffnen von Hauptschaltern in der Stromrichterschaltung, sodass eine Parallelimpedanz mindestens eines aus dem Ausgang und dem Eingang des elektronischen Moduls sich nicht auf eine Messung der Impedanz der photovoltaischen Gleichstromquelle (152) auswirkt.

## Revendications

**1.** Appareil (152, 264, 210a, 264a) comprenant :

une source d'énergie photovoltaïque à courant continu (152);
un module électronique (264) comprenant une entrée et une sortie, dans lequel l'entrée est connectée à la source d'énergie en courant continu photovoltaïque ;
une unité d'impédance (210a) configurée pour détecter une impédance, un courant ou une tension à la sortie du module électronique ;
dans lequel le module électronique (264) comprend en outre une dérivation (264a) connectée entre l'entrée et la sortie du module électronique, dans laquelle la dérivation est un interrupteur unipolaire qui est configuré pour être en circuit ouvert lorsque le module électronique reçoit de l'énergie du source d'énergie photovoltaïque à courant continu.

**2.** Appareil selon la revendication 1, dans lequel le module électronique (264) comprend en outre un circuit convertisseur d'énergie.

**3.** Appareil selon l'une quelconque des revendications précédentes, comprenant en outre une source de courant alternatif, dans lequel la source de courant alternatif est agencée pour superposer un courant alternatif sur une ligne électrique (216) connectée à la sortie du module électronique (264), dans lequel l'impédance de la source d'énergie à courant continu photovoltaïque (152) est sensible au courant alternatif.

**4.** Appareil selon la revendication 3, dans lequel l'unité d'impédance (210a) est fonctionnellement fixée à la ligne électrique (216).

**5.** Appareil selon l'une quelconque des revendications précédentes, dans lequel l'unité d'impédance (210a) est située à la sortie du module électronique (264) ou fait partie de celui-ci.

**6.** Appareil selon l'une quelconque des revendications précédentes, dans lequel, lorsque le module électronique (264) ne reçoit pas d'énergie de la source d'énergie en courant continu photovoltaïque (152), les interrupteurs principaux dans le circuit convertisseur d'énergie sont en circuit ouvert de telle sorte qu'une impédance shunt du la sortie et l'entrée du module électronique n'affecte pas une mesure de l'impédance de la source d'énergie en courant continu photovoltaïque (152).

**7.** Appareil selon l'une quelconque des revendications précédentes, comprenant :
un microprocesseur (21) qui compare l'impédance de la source d'énergie à courant continu photovoltaïque avec une valeur d'impédance précédente stockée dans une mémoire pour produire une valeur de différence, et émet une alerte si la valeur de différence est supérieure ou inférieure à une certaine valeur de seuil.

**8.** Appareil selon l'une quelconque des revendications précédentes, comprenant en outre :

une pluralité de sources d'énergie photovoltaïques à courant continu (152);
une pluralité de modules électroniques (264), chacun de la pluralité de modules électroniques (264) ayant une entrée connectée à l'une respective de la pluralité de sources d'énergie en courant continu photovoltaïque (152), et chacun de la pluralité de modules électroniques (264) ayant une sortie connectée dans une chaîne série (218b) connectée à une ligne d'alimentation (216) ; et

une pluralité de dérivations (264a), chacune de la pluralité de dérivations (264a) étant connectée entre l'entrée et la sortie de l'un respectif de la pluralité de modules électroniques (264) et adaptée pour dériver une impédance de l'une respective parmi la pluralité de sources d'énergie en courant continu photovoltaïques (152) connectées à l'entrée de l'un respectif de la pluralité de modules électroniques (264) à la sortie de l'un respectif de la pluralité de modules électroniques (264).

9. Procédé de fonctionnement d'un appareil selon l'une quelconque des revendications 1 à 8, le procédé comprenant les étapes consistant à :

dériver, de l'entrée vers la sortie du module électronique (264) à l'aide de la dérivation (264a), l'impédance de la source d'énergie photovoltaïque en courant continu (152) ;
capter, avec l'unité d'impédance (210a, 210b), l'impédance, un courant, ou une tension en sortie du module électronique (264); et
détecter une variation de l'impédance, du courant ou de la tension en sortie du module électronique (264) supérieure à un seuil préalablement déterminé.

10. Procédé selon la revendication 9, comprenant l'étape consistant à :
alerter d'un vol potentiel de la source d'énergie en courant continu photovoltaïque (152) en réponse à la variation de l'impédance, du courant ou de la tension supérieure à un seuil préalablement déterminé.

11. Procédé selon l'une quelconque des revendications 9 à 10, comprenant l'étape consistant à alimenter l'unité d'impédance par l'un parmi : un courant de la source d'énergie à courant continu photovoltaïque, de l'énergie reçue d'un panneau photovoltaïque ou un élément de stockage de charge.

12. Procédé selon l'une quelconque des revendications 9 à 11, dans lequel le module électronique (264) comprend le circuit convertisseur d'énergie, et dans lequel le procédé comprend en outre l'étape consistant à :
ouvrir des interrupteurs principaux dans le circuit convertisseur d'énergie de sorte qu'une impédance shunt d'au moins l'une parmi la sortie et l'entrée du module électronique n'affecte pas une mesure de l'impédance de la source d'énergie en courant continu photovoltaïque (152).

A.C Power

158

150
INVERTER

156

152
PHOTOVOLTAIC
PANEL

D.C Power

153

154

157

*Fig. 1a*

Fig. 1b

1700(a)

100 Permanently attach memory
module 154 to photovoltaic panel 152

102 Attach communication
module 153 to the inverter 150

103 Write code 1000 in memory 159

104 Read code 1000 using
communication module 153

105 Store code 1000
as code 2000 in memory 175

*Fig. 1c*

1700(b)

1700(a)

```
1200 Microprocessor 160 reads
           code 1000
```

```
1202 Microprocessor 160 compares read code
           1000 with code 2000
```

1204
All Codes
Present &
Same?                    Yes

NO

```
1206 Microprocessor 160
    closes inverter 150
           down
```

*Fig. 1d*

*Fig. 1e*

1750(a)

```
┌─────────────────────────────────────┐
│      100 Permanently attach memory   │
│  module 154 to the photovoltaic panel 152 │
└─────────────────────────────────────┘
                   │
                   ▼
┌─────────────────────────────────────┐
│   102 Attach communication module    │
│           153 to inverter 150         │
└─────────────────────────────────────┘
                   │
                   ▼
┌─────────────────────────────────────┐
│   103 Write code1000 in memory 159    │
└─────────────────────────────────────┘
                   │
                   ▼
┌─────────────────────────────────────┐
│      1304 Read code 1000 using       │
│          the remote server 172        │
└─────────────────────────────────────┘
                   │
                   ▼
┌─────────────────────────────────────┐
│     1305 Remote server 172 stores    │
│            code 2000  as code         │
│    3000 in remote storage 172a        │
└─────────────────────────────────────┘
```

*Fig. 1f*

1750(b)

1750(a)

```
1400 Remote server 172 reads
       codes 1000 and 2000
```

```
1402 Remote server 172 compares
codes 1000 & 2000 with code 3000
      in remote storage 172a
```

1404
All Codes
Present &
Same?

Yes

No

```
1406 Remote server 172
Closes Inverter 150 down
```

*Fig. 1g*

*Fig. 1h*

1780(a)

```
┌────────────────────────────────────┐
│   100 Permanently attach memory    │
│ module 154b to photovoltaic panel 152 │
└────────────────────────────────────┘
                  │
                  ▼
      ┌──────────────────────────┐
      │ 102 Attach communication │
      │  module 153 to inverter 150 │
      └──────────────────────────┘
                  │
                  ▼
   ┌──────────────────────────────────┐
   │ 103 Write code 1000 in memory 159 │
   └──────────────────────────────────┘
                  │
                  ▼
 ┌────────────────────────────────────────┐
 │ 1504 Read code 1000 and GPS code 4000  │
 │        using remote server 172         │
 └────────────────────────────────────────┘
                  │
                  ▼
 ┌────────────────────────────────────────┐
 │ 1505 Remote server 172 stores codes 1000 │
 │   & 4000 and code 2000 as code 3000 in  │
 │           remote storage 172a            │
 └────────────────────────────────────────┘
                  │
                  ▼
```

*Fig. 1i*

1780(b)

1780(a)

```
┌─────────────────────────────────┐
│ 1600 Remote server 172 reads codes │
│        1000, 4000 & 2000          │
└─────────────────────────────────┘
```

```
┌─────────────────────────────────┐
│ 1602 Remote server 172 compares read │
│ codes 1000, 4000 & 2000 with code 3000 │
│      in remote storage 172a       │
└─────────────────────────────────┘
```

1604
All Codes
Present &
Same?

Yes

NO

```
┌─────────────────────────────────┐
│ 1406 Remote server 172 closes     │
│       Inverter 150 down           │
└─────────────────────────────────┘
```

*Fig. 1j*

*Fig. 1k*

1700(a)

1700(b)  1800(b)

*Fig. 1I*

1800(b)

1200b Microprocessor 177 reads
code 2000 in communication module 153

1202b Microprocessor 177 compares code
2000 with code 1000 in memory module 154c

1204b
All Codes
Present &
Same?

Yes

NO

1206b Microprocessor 177
closes panel 152 down

*Fig. 1m*

*Fig. 2a*

*Fig. 2b*

205 Apply alternating current (AC) from AC current source to the DC power line

207 Sense impedance which responds to the AC current

209 Store impedance datum

211 Transmit impedance datum

213 Compare impedance datum

215 Charge electrical storage device

217 Alerting of theft

203

*Fig. 2c*

Fig. 2d

*Fig. 2e*

230 Measuring impedance, current & voltage.

232 Storing measurement datum.

233 Store charge.

234 Transmit datum.

236 Receive datum.

238 Compare stored datum with received datum.

240 Change in threshold of datum? — No

Yes

242 Alerting of potential theft.

219

*Fig. 2f*

Fig. 2g

263 Connect an impedance probe to DC power line.

265 Transmit a probe signal to DC power line.

267 Sense an impedance responsive to the probe signal.

269 Compare the sensed impedance with a previously stored impedance value.

271 Comparison above or below a certain threshold?

No

Yes

273 Alert of theft.

261c

*Fig. 2h*

Fig. 3a

Fig. 3b

303 Signaling Electronic module

↓

305 Electronic module reverse biases panels

↓

307 Capturing Image frames

↓

309 Analyzing image frames

↓

311 Ascertain presence of panels

↓

313 Alerting of potential theft

*Fig. 3c*

311

*Fig. 4a*

405 Transmitting a signal

407 Monitoring for the signal

409 Sensing absence of the signal

403

*Fig. 4b*

Fig. 4c

405

423 Measuring signal strength.

425 Change in
threshold
of signal strength?

No

Yes

427 Detecting an object.

429 Alerting of potential theft.

421

*Fig. 4d*

Fig. 5a

501

520a

520b

590

520a  522  524a

528

524b

526

A

*Fig. 5b*

532

D                    E

530

505

534

*Fig. 5d*

528 & 524b

550

152

552

520

*Fig. 5c*

503 Measure field strength

505 Change in threshold of electrical field strength?

No

Yes

507 Detecting an object

509 Alerting of potential theft

*Fig. 5e*

511

*Fig. 6a*

152
panel

S₁

612

C_s

L_s

602

606

*Fig. 6b*

603 Superimpose a control signal to the DC line.

605 Connect resonant circuit to panel/ string .

607 Superimpose a test signal to the DC line.

609 Sense reflected test signal

611 Change in threshold of reflected signal?

No

611

Yes

613 Alerting of potential theft

*Fig. 6c*

Fig. 7a

701

703 Sending a signal from central controller.

705 Panel module constructs a confirmation signal.

707 Receiving a confirmation signal.

709 Comparing confirmation signal with look up table stored in central controller. Yes

711 Comparison is good?

Yes

No

731

713 Alerting of theft.

*Fig. 7b*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009146667 A
- DE 1993012710
- US 2008106250 A
- WO 2009026602 A